# EUROPEAN PATENT APPLICATION

(11) **EP 1 211 561 A2**
(43) Date of publication of application: **05.06.2002**
(21) Application number: 01128550.9
(22) Date of filing: 29.11.2001
(51) Int. Cl.: G03F 7/20

(54) **Illumination apparatus**

(30) Priority: 29.11.2000 JP 2000363225; 15.03.2001 JP 2001074240
(71) Applicant: Nikon Corporation, Tokyo 100-8331 (JP)
(72) Inventor: Tanitsu, Osamu, Nikon Corporation, Tokyo 100-8331 (JP); Shibuya, Masato, Nikon Corporation, Tokyo 100-8331 (JP); Toyoda, Mitsunori, Nikon Corporation, Tokyo 100-8331 (JP)
(74) Representative: TER MEER STEINMEISTER & PARTNER GbR

(57) **Abstract**

An illumination optical apparatus successfully realizes mutually different illumination conditions in orthogonal two directions on an illumination objective plane. A magnification-varying optical system for similarly changing the entire size of a secondary multiple light source is arranged in an optical path between a first optical integrator for forming a first multiple light source on the basis of a light beam from a light source and a second optical integrator for forming the second multiple light source having light sources of a larger number on the basis of a light beam from the first multiple light source. The apparatus further comprises an aspect ratio-changing element for changing the aspect ratio of the incoming light beam in order to change the angle of incidence of the incoming light beam into the first optical integrator in a predetermined direction.

## Description

### BACKGROUND OF THE INVENTION

### Field of the Invention:

The present invention relates to an illumination optical apparatus and an exposure apparatus provided with the illumination optical apparatus. In particular, the present invention relates to an illumination optical apparatus which is preferable for an exposure apparatus to produce, in the lithography step, microdevices including, for example, semiconductor elements, image-pickup elements, liquid crystal display elements, and thin film magnetic heads.

### Description of the Related Art:

In a typical exposure apparatus of this type, a light beam, which is radiated from a light source, forms a secondary light source which is provided as a substantial surface light source (surface illuminant) composed of a large number of light sources by the aid of a fly's eye lens which serves as an optical integrator. The light beam from the secondary light source is restricted by an aperture diaphragm which is arranged in the vicinity of the rear side focal plane of the fly's eye lens, and then the light beam comes into a condenser lens.

The light beam, which is collected by the condenser lens, illuminates, in a superimposed manner, a mask on which a predetermined pattern is formed. The light beam, which has passed through the pattern on the mask, passes through a projection optical system to form an image on a wafer. Accordingly, the mask pattern is subjected to projection exposure (transfer) onto the wafer. The pattern formed on the mask is highly integrated. In order to correctly transfer the fine pattern onto the wafer, it is indispensable to obtain a uniform illuminance distribution on the wafer.

In consideration of the situation as described above, a technique attracts the attention, in which a circular secondary light source is formed on the rear side focal plane of the fly's eye lens, and its size is changed to change the coherency σ of illumination (σ value = diameter of aperture diaphragm / diameter of pupil of projection optical system, or σ value = numerical aperture on outgoing side of illumination optical system / numerical aperture on incoming side of projection optical system). On the other hand, a technique attracts the attention, in which an annular or quadrupole secondary light source is formed on the rear side focal plane of a fly's eye lens to improve the depth of focus and/or the resolution of the projection optical system.

However, as for the conventional techniques as described above, the cross-sectional configuration of the light beam coming into one point on the mask as an illumination objective plane resides in an identical positional relationship in relation to two directions perpendicular to one another on the mask, either in the case of the conventional circular illumination based on the circular secondary light source or in the case of the modified illumination (annular illumination or quadrupole illumination) based on the annular or quadrupole secondary light source. In other words, in the conventional technique, the illumination condition is identical in the two directions perpendicular to one another on the illumination objective plane. As a result, when the mask pattern involves any orientation, it is impossible to realize an optimum illumination condition in each of the perpendicular two directions on the mask. On the other hand, in recent years, it is sincerely demanded that the pattern on the mask is correctly transferred under an optimum illumination condition, and the optical performance of the projection optical system is successfully confirmed highly accurately at the same time when the pattern on the mask is correctly transferred.

The present invention has been made taking the foregoing problems into consideration, an object of which is to provide an illumination optical apparatus which makes it possible to realize mutually different illumination conditions in two directions perpendicular to one another on an illumination objective plane, and an exposure apparatus which is provided with the illumination optical apparatus. Another object of the present invention is to provide a method for producing microdevices, which makes it possible to produce a good microdevice under a good illumination condition by using an exposure apparatus which is capable of setting optimum illumination conditions in perpendicular two directions on a mask formed with a pattern with certain orientation. Still another object of the present invention is to provide, for example, an exposure apparatus and an exposure method in which a pattern on a mask can be correctly transferred under an appropriate illumination condition, and the optical performance of a projection optical system can be confirmed highly accurately at the same time when the pattern on the mask is correctly transferred.

### SUMMARY OF THE INVENTION

According to a first aspect of the present invention, there is provided an illumination optical apparatus for illuminating an illumination objective plane with a light beam from a light source, comprising:
an optical integrator (6, 8, 8a) which is arranged in an optical path between the light source (1) and the illumination objective plane and forms a multiple light source on the basis of the light beam from the light source (1); and
an aspect ratio-changing element (10, 15, 16) which is arranged in an optical path between the light source and the optical integrator and which changes an aspect ratio of an incoming light beam in order to change an angle of incidence of the incoming light beam in a predetermined direction into the optical integrator.

In the illumination optical apparatus described above, the optical integrator may include a first optical integrator (6) which is arranged in an optical path between the light source and the illumination objective plane and forms a first multiple light source on the basis of the light beam from the light source, and a second optical integrator (8) which is arranged in an optical path between the first optical integrator and the illumination objective plane and forms a second multiple light source having light sources of a number larger than that of the first multiple light source on the basis of a light beam from the first multiple light source. In this case, the illumination optical apparatus may further comprise a magnification-varying optical system (7) which is arranged in an optical path between the first optical integrator (6) and the second optical integrator (8) and which similarly changes an entire size of the second multiple light source.

The illumination optical apparatus may further comprise a guiding optical system (9, 17, 18) which is arranged in the optical path between the optical integrator and the illumination objective plane and guides the light beam from the optical integrator to the illumination objective plane, and a light beam-converting element (4, 4a, 11a, 11b, 11c) which is arranged in the optical path between the light source and the optical integrator and converts the light beam from the light source into a light beam having a predetermined cross-sectional configuration or a light beam having a predetermined light intensity distribution.

The aspect ratio-changing element (10, 15, 16) may be constructed to be rotatable about a center of an optical axis of the aspect ratio-changing element. The aspect ratio-changing element may include a first aspect ratio-changing element (10, 16) which is arranged in the optical path between the light source and the optical integrator and changes an angle of incidence of the incoming light beam into the (first) optical integrator in a first direction, and a second aspect ratio-changing element (15) which is arranged in the optical path between the light source and the optical integrator and changes an angle of incidence of the incoming light beam into the (first) optical integrator in a second direction traverse to the first direction. The aspect ratio-changing element may include a first prism (10a, 15a, 16a) which has a refractive surface having a concave cross section in the predetermined direction, a second prism (10b, 15b, 16b) which has a refractive surface having a convex cross section formed complementarily with the refractive surface having the concave cross section of the first prism, and a driving unit (25, 28c) which is connected to at least one of the first prism and the second prism and moves at least one of the first prism and the second prism along an optical axis. In this case, the concave cross section of the first prism may have a V-shaped configuration.

According to a second aspect of the present invention, there is provided an illumination optical apparatus comprising:
an illumination optical system which illuminates an illumination objective; and
a varying mechanism (7, 14, 15, 16) which is attached to the illumination optical system and varies at least one of a size and a shape of an illumination light beam on a pupil of the illumination optical system, wherein:
   the varying mechanism includes a first displacement unit (15) which is arranged in an illumination optical path and displaces the illumination light beam symmetrically with respect to an optical axis in a first direction perpendicular to the optical axis of the illumination optical system.

In the illumination optical apparatus according to the second aspect of the present invention, the varying mechanism may further include a second displacement unit (16) which is arranged in the illumination optical path and displaces the illumination light beam symmetrically with respect to the optical axis in a second direction which is perpendicular to the optical axis and which intersects the first direction, and a magnification-varying optical system (7) which is arranged in the illumination optical path and varies the size of the illumination light beam.

In the illumination optical apparatus according to the second aspect of the present invention, the varying mechanism may further include an annular ratio-varying unit (14) which is arranged in the illumination optical path and adds a function to convert the illumination light beam into one having an annular configuration with a desired annular ratio, and/or a magnification-varying optical system (7) which is arranged in the illumination optical path and varies the size of the illumination light beam. The annular ratio-varying unit (14) may be a conical axicon.

In the illumination optical apparatus according to the second aspect of the present invention, the illumination optical system may include a light shape converter (4, 4a, 11a, 11b, 11c) which is arranged in the illumination optical path and converts the shape of the illumination light beam into a desired light beam shape and which guides the illumination light beam converted to have the desired light beam shape to the varying mechanism. The light shape converter may include a first diffractive optical member (4, 11a) which is capable of inserting the illumination optical path and converts the shape of the illumination light beam into a first light beam shape, and a second diffractive optical member (4a, 11b, 11c) which is provided exchangeably with the first diffractive optical member and which converts the shape of the illumination light beam into a second light beam shape. The illumination optical system may include an optical integrator (8a) which is arranged in an optical path between the varying mechanism and the illumination objective and which uniformly illuminates the illumination objective.

According to a third aspect of the present invention, there is provided an exposure apparatus for transforming a pattern on a mask onto a workpiece comprising:
the illumination optical apparatus according to the first or second aspect, which illuminates the mask arranged at the illumination objective plane; and
a projection optical system which is arranged in an optical path between the mask and the workpiece and projects an image of the pattern onto the workpiece.

According to a fourth aspect of the present invention, there is provided a method for producing a microdevice, comprising an exposing step of exposing the workpiece with the pattern on the mask with the exposure apparatus according to the third aspect of the present invention, and a developing step of developing the workpiece exposed in the exposing step.

According to a fifth aspect of the present invention, there is provided an exposure method for exposing a workpiece with a pattern on a mask, comprising:
an illuminating step of illuminating the mask via an illumination optical system with an optical axis; and
a projecting step of projecting an image of the pattern on the mask onto the workpiece, wherein:
   the illuminating step comprises displacing an illumination light beam symmetrically with respect to an intervening optical axis in a first direction perpendicular to the optical axis of the illumination optical system on a pupil of the illumination optical system.

In a first form of the exposure method described above, the illuminating step may further comprise converting the illumination light beam into one having an annular configuration on the pupil of the illumination optical system, and displacing the illumination light beam symmetrically with respect to the optical axis in a second direction which is perpendicular to the optical axis and which intersects the first direction. In this case, the illuminating step may further comprise changing a size of the illumination light beam.

In a second form of the exposure method described above, the illuminating step may further comprise displacing the illumination light beam symmetrically with respect to the optical axis in a second direction which is perpendicular to the optical axis and which intersects the first direction, and changing a size of the illumination light beam.

In a third form of the exposure method described above, the illuminating step may further comprise converting the illumination light beam into one having an annular configuration on the pupil of the illumination optical system, and converting an annular ratio of the converted annular illumination into a desired annular ratio. The illumination step may further comprise changing a size of the illumination light beam. The illuminating step may further comprise a second displacing step of displacing the illumination light beam symmetrically with respect to the optical axis in a second direction which is perpendicular to the optical axis and which intersects the first direction.

In the first to third forms of the exposure method described above, the illuminating step may further comprise converting a shape of the illumination light beam into a desired light beam shape before displacing the illumination light beam or converting the illumination light beam into one having the annular configuration. The light shape-converting step may include converting the shape of the illumination light beam into a first light beam shape by using a first diffractive optical member, and converting the shape of the illumination light beam into a second light beam shape by using a second diffractive optical member which is provided exchangeably with the first diffractive optical member.

In a fourth form of the exposure method described above;
the illuminating step may further comprise a changing step of changing an illumination condition for the mask;
the changing step may comprise a selecting step of selecting at least one of a first setting step of setting a first illumination condition for the illumination optical system, and a second setting step of setting a second illumination condition for the illumination optical system;
the first setting step may comprise a step of converting the illumination light beam into one having an annular configuration on the pupil of the illumination optical system, a step of displacing the illumination light beam symmetrically with respect to the optical axis of the illumination optical system in the first direction which is perpendicular to the optical axis, and a step of displacing the illumination light beam symmetrically with respect to the optical axis in a second direction which is perpendicular to the optical axis and which intersects the first direction; and
the second setting step may comprise a step of displacing the illumination light beam symmetrically with respect to the optical axis of the illumination optical system in the first direction which is perpendicular to the optical axis, a step of displacing the illumination light beam symmetrically with respect to the optical axis in the second direction which is perpendicular to the optical axis and which intersects the first direction, and a step of changing a size of the illumination light beam.

In a fifth form of the exposure method described above;
the illuminating step may further comprise a changing step of changing an illumination condition for the mask;
the changing step may comprise a selecting step of selecting at least one of a first setting step of setting a first illumination condition for the illumination optical system, and a second setting step of setting a second illumination condition for the illumination optical system;
the first setting step may comprise a step of converting the illumination light beam into one having an annular configuration having a desired annular ratio on the pupil of the illumination optical system, and a step of changing a size of the illumination light beam; and
the second setting step may comprise a step of displacing the illumination light beam symmetrically with respect to the optical axis of the illumination optical system in a predetermined direction which is perpendicular to the optical axis, and a step of changing the size of the illumination light beam.

In a sixth form of the exposure method described above;
the illuminating step may further comprise a changing step of changing an illumination condition for the mask;
the changing step may comprise a selecting step of selecting at least one of a first setting step of setting a first illumination condition for the illumination optical system, a second setting step of setting a second illumination condition for the illumination optical system, and a third setting step of setting a third illumination condition for the illumination optical system;
the first setting step may comprise an annular ratio-varying step of converting the illumination light beam into one having an annular configuration having a desired annular ratio on the pupil of the illumination optical system, a step of displacing the illumination light beam symmetrically with respect to the optical axis of the illumination optical system in the first direction which is perpendicular to the optical axis, and a step of displacing the illumination light beam symmetrically with respect to the optical axis in a second direction which is perpendicular to the optical axis and which intersects the first direction;
the second setting step may comprise a step of converting the illumination light beam into one having an annular configuration having a desired annular ratio, and a step of changing a size of the illumination light beam; and
the third setting step may comprise a step of displacing the illumination light beam symmetrically with respect to the optical axis of the illumination optical system in the first direction which is perpendicular to the optical axis, a step of displacing the illumination light beam symmetrically with respect to the optical axis in the second direction which is perpendicular to the optical axis and which intersects the first direction, and a step of changing the size of the illumination light beam.

According to a sixth aspect of the present invention, there is provided an exposure method for exposing a workpiece with a pattern on a mask, comprising:
an illuminating step of illuminating the mask via an illumination optical system;
a projecting step of projecting an image of the pattern on the mask onto the workpiece by using a projection optical system; and
a measuring step of measuring an optical characteristic of the projection optical system, wherein the illuminating step comprises:
   an exposure condition-setting step of setting a σ value as an illumination condition to be within a range of 0.4 ≤ σ ≤ 0.95 when the projecting step is executed; and
   a measuring condition-setting step of setting the σ value as the illumination condition to be within a range of 0.01 ≤ σ ≤ 0.3 when the measuring step is executed. This method may further comprise:
      a scanning step of moving the mask and the workpiece in a scanning direction when the projecting step is executed, wherein:
         the illuminating step comprises a step of forming a rectangular illumination area having a length Ls of a longitudinal direction and a length L1 of a transverse direction on the mask; and
         a relationship of 0.05 < Ls/L1 < 0.7 is satisfied.

According to a seventh aspect of the present invention, there is provided an exposure apparatus for exposing a workpiece with a pattern on a mask, comprising:
an illumination optical system which is arranged in an optical path upstream of the mask and illuminates the mask; and
a projection optical system (PL) which is arranged in an optical path between the mask and the workpiece and projects an image of the pattern on the mask onto the workpiece, wherein:
the illumination optical system includes an illumination condition-setting mechanism (4a, 4b, 5, 7, 10, 11a to 11c, 12, 14 to 16, 71, 71a) which is attached to the illumination optical system and sets a σ value as an illumination condition to be within a range of 0.4 ≤ σ ≤ 0.95 when the workpiece is exposed with the pattern on the mask and which sets the σ value as the illumination condition to be within a range of 0.01 ≤ σ ≤ 0.3 when an optical characteristic of the projection optical system is measured.

The exposure apparatus according to the seventh aspect of the present invention may further comprise a scanning unit which moves the mask and the workpiece in a scanning direction when the workpiece is exposed with the pattern on the mask, wherein:
a relationship of 0.05 < Ls/L1 < 0.7 is satisfied provided that Ls represents a length in a transverse direction of an illumination area formed on the mask by the illumination optical system, and L1 represents a length in a longitudinal direction of the illumination area formed on the mask by the illumination optical system.

### BRIEF DESCRIPTION OF THE DRAWINGS

Fig. 1 schematically shows an arrangement of an exposure apparatus provided with an illumination optical apparatus according to a first embodiment of the present invention.
Fig. 2 schematically shows an arrangement of a quadrupole secondary light source formed on a rear side focal plane of a fly's eye lens.
Figs. 3A and 3B schematically show an arrangement of a pair of prisms for constructing a V-shaped axicon arranged in an optical path of an afocal zoom lens.
Figs. 4A-4D schematically illustrate the influence exerted on the quadrupole secondary light source by the change of the spacing distance of the V-shaped axicon, the change of the magnification of the afocal zoom lens, and the change of the focal length of the zoom lens.
Figs. 5A-5D schematically illustrate the influence exerted on the annular secondary light source by the change of the spacing distance of the V-shaped axicon, the change of the magnification of the afocal zoom lens, and the change of the focal length of the zoom lens.
Figs. 6A-6C show illustrative modified embodiments concerning the shape of the refracting plane of the V-shaped axicon.
Figs. 7A and 7B show illustrative modified embodiments concerning the rotation and the combination of the V-shaped axicon.
Fig. 8 shows a flow chart of a technique adopted to obtain a semiconductor device as a microdevice.
Fig. 9 shows a flow chart of a technique adopted to obtain a liquid crystal display device as a microdevice.
Fig. 10 schematically shows an arrangement of an exposure apparatus provided with an illumination optical apparatus according to a second embodiment of the present invention.
Fig. 11 shows a perspective view schematically illustrating an arrangement of three axicons arranged in an optical path between a front side lens group and a rear side lens group of an afocal lens in the second embodiment.
Fig. 12 illustrates the function of a conical axicon for a secondary light source formed in the quadrupole illumination in the second embodiment.
Fig. 13 illustrates the function of a zoom lens for a secondary light source formed in the quadrupole illumination in the second embodiment.
Figs. 14A-14C illustrate the function of a first v-shaped axicon and a second V-shaped axicon for a secondary light source formed in the quadrupole illumination in the second embodiment.
Fig. 15 illustrates the function of a conical axicon, a zoom lens, a first V-shaped axicon, and a second V-shaped axicon for each of circular surface light sources formed in the quadrupole illumination in the second embodiment.
Fig. 16 illustrates each of surface light sources and a movement range of the surface light source formed by three types of diffracting optical elements for the quadrupole illumination having different characteristics in the second embodiment.
Fig. 17 illustrates each of surface light sources and movement and deformation of the surface light source formed by four types of diffracting optical elements for the quadrupole illumination having different characteristics in a first modification of the second embodiment.
Fig. 18 illustrates each of surface light sources and movement and deformation of the surface light source formed by four types of diffracting optical elements for the quadrupole illumination having different characteristics in the first modification of the second embodiment.
Fig. 19 illustrates each of surface light sources and movement and deformation of the surface light source formed by two types of diffracting optical elements for the quadrupole illumination having different characteristics in a second modification of the second embodiment.
Fig. 20 illustrates the function of the conical axicon for the secondary light source formed in the annular illumination in the second embodiment.
Fig. 21 illustrates the function of the zoom lens for the secondary light source formed in the annular illumination in the second embodiment.
Figs. 22A-22C illustrate the function of the first V-shaped axicon and the second V-shaped axicon for the secondary light source formed in the annular illumination in the second embodiment.
Figs. 23A and 23B illustrate a third modification of the second embodiment.
Figs. 24A-24C illustrate the function of the first V-shaped axicon and the second V-shaped axicon for the secondary light source formed in the circular illumination in the second embodiment.
Fig. 25 schematically shows an arrangement of an exposure apparatus provided with an illumination optical apparatus according to a third embodiment of the present invention.
Fig. 26 shows a perspective view schematically illustrating an arrangement of a pair of V-shaped axicons arranged in-an optical path of an afocal lens in the third embodiment.
Fig. 27 schematically shows an arrangement of an exposure apparatus provided with an illumination optical apparatus according to a fourth embodiment of the present invention.
Fig. 28 shows a perspective view schematically illustrating an arrangement of a conical axicon and a V-shaped axicon arranged in an optical path of an afocal lens in the fourth embodiment.
Fig. 29 schematically shows an arrangement of an exposure apparatus provided with an illumination optical apparatus according to a fifth embodiment of the present invention.
Figs. 30A and 30B illustrate the function of a second diffracting optical element in the fifth embodiment.

### DESCRIPTION OF THE PREFERRED EMBODIMENTS

In a typical embodiment of the present invention, for example, a light beam-converting element such as a diffraction optical element (diffractive optical element: DOE) is used to convert a light beam from a light source into a light beam having a quadrupole (four-spot) or annular configuration. The four-spot or annular light beam is collected by a predetermined optical system, and it comes, from an oblique direction with respect to the optical axis, into a first optical integrator such as a micro fly's eye lens or a micro lens array (hereinafter referred to as "micro fly's eye"). Accordingly, a first multiple light source is formed by the micro fly's eye. The light beam from the first multiple light source passes through a predetermined optical system, and then it forms a second multiple light source, i.e., a four-spot or annular secondary light source by the aid of a second optical integrator such as a fly's eye lens.

In the present invention, the apparatus is provided with an aspect ratio-changing element for changing the aspect ratio of the incoming light beam, in order to change the angle of incidence of the incoming light beam into the micro fly's eye in a predetermined direction. The aspect ratio-changing element includes, for example, a first prism which has a refractive surface having a V-shaped concave cross section in a predetermined direction, and a second prism which has a refractive surface having a V-shaped convex cross section formed complementarily with respect to the refractive surface of the V-shaped concave cross section of the first prism. Further, at least any one of the first prism and the second prism is constructed to be movable along the optical axis.

Therefore, when the spacing distance between the concave refractive surface of the first prism and the V-shaped convex refractive surface of the second prism is changed, the entire size of the four-spot or annular secondary light source is changed in a predetermined direction. As a result, the illumination optical apparatus according to the present invention makes it possible to realize mutually different illumination conditions in two directions perpendicular to one another on the illumination objective plane. Therefore, when the exposure apparatus, which is incorporated with the illumination optical apparatus of the present invention, is used, it is possible to set optimum illumination conditions in the two orthogonal directions perpendicular to one another on a mask on which the pattern has orientation. Thus, a good microdevice can be produced under a good illumination condition.

Embodiments of the present invention will be explained on the basis of the accompanying drawings.

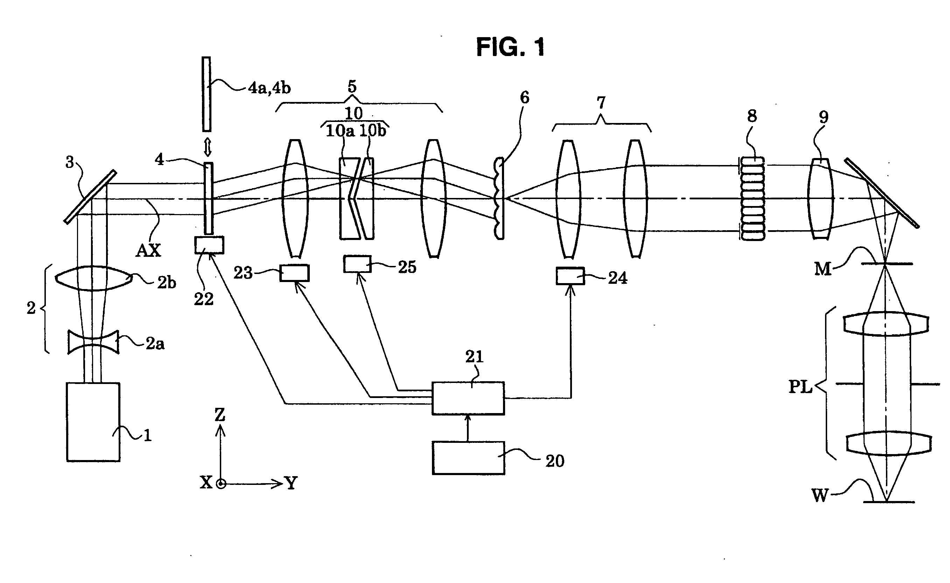

Fig. 1 schematically shows an arrangement of an exposure apparatus provided with an illumination optical apparatus according to a first embodiment of the present invention. With reference to Fig. 1, the X, Y and Z axes are set as follows. That is, the Z axis extends in the direction of the normal line of a wafer as a photosensitive substrate, the Y axis extends in the direction parallel to the plane of paper of Fig. 1 in the wafer surface, and the X axis extends in the direction perpendicular to the plane of paper of Fig. 1 in the wafer surface. In Fig. 1, the illumination optical apparatus is set to perform the quadrupole illumination.

The exposure apparatus shown in Fig. 1 is provided with an excimer laser light source for supplying the light having a wavelength of, for example, 248 nm (KrF) or 193 nm (ArF) as a light source 1 for supplying the exposure light beam (illumination light beam). The substantially parallel light beam, which is radiated from the light source 1 in the Z direction, comes into a beam expander 2 which has a rectangular cross section extending slenderly in the X direction and which is composed of a pair of lenses 2a, 2b. The respective lenses 2a, 2b have the negative refractive power and the positive refractive power in the plane of paper of Fig. 1 (in the YZ plane) respectively. Therefore, the light beam, which comes into the beam expander 2, is enlarged in the plane of paper of Fig. 1, and it is shaped into a light beam having a predetermined rectangular cross section.

The substantially parallel light beam, which has passes through the beam expander 2 as the shaping optical system, is deflected by a bending mirror 3 in the Y direction, and then it comes into a diffracting optical element (diffractive optical element: DOE) 4 for the quadrupole illumination. In general, the diffracting optical element is constructed such that the difference in height having a pitch approximately equal to the wavelength of the exposure light beam (illumination light beam) is formed on a glass substrate. The diffracting optical element has a function to diffract the incoming light beam at a desired angle. The light beam, which comes into the diffracting optical element 4 for the quadrupole illumination, is diffracted in specified four directions at equal angles about the center of the optical axis AX to provide four light beams, i.e., the four-spot light beam. As described above, the diffracting optical element 4 constitutes a light beam-converting element for converting the light beam from the light source 1 into the four-spot light beam.

The diffracting optical element 4 is insertable and detachable with respect to the illumination optical path, and it is exchangeable with a diffracting optical element 4a for the annular illumination and a diffracting optical element 4b for the conventional circular illumination. The construction and the function of the diffracting optical element 4a for the annular illumination and the diffracting optical element 4b for the conventional circular illumination will be described later on. In this embodiment, the diffracting optical element 4 for the quadrupole illumination is exchanged with the diffracting optical element 4a for the annular illumination or the diffracting optical element 4b for the conventional circular illumination by means of a first driving system 22 which is operated on the basis of a command from a control system 21.

The four-spot light beam, which is formed by the aid of the diffracting optical element 4, comes into an afocal zoom lens (magnification-varying relay optical system) 5 to form four spot images (spot-shaped light sources) on the pupil plane. The light beams from the four spot images form a substantially parallel light beam which outgoes from the afocal zoom lens 5 and which comes into a micro fly's eye 6. The afocal zoom lens 5 is constructed such that the diffracting optical element 4 and the light-incoming surface of the micro fly's eye 6 are maintained to be in an optically substantially conjugate relationship, and the magnification can be continuously changed within a predetermined range while maintaining the afocal system (afocal optical system). In this arrangement, the magnification of the afocal zoom lens 5 is changed by using a second driving system 23 which is operated on the basis of a command from the control system 21.

Accordingly, the light beam comes into the light-incoming surface of the micro fly's eye 6 from an oblique direction substantially symmetrically with respect to the optical axis AX. The micro fly's eye 6 is an optical element composed of a large number of regular hexagonal minute lenses having the positive refractive power arranged densely in the vertical and lateral directions. In general, the micro fly's eye is constructed such that a plane parallel glass plate is subjected to an etching treatment to form a group of minute lenses.

In this arrangement, the respective minute lenses, which constitute the micro fly's eye, are more minute than the respective lens elements which constitute the fly's eye lens. In the micro fly's eye, the large number of minute lenses are formed in an integrated manner without being isolated from each other, unlike the fly's eye lens which is composed of the lens elements isolated from each other. However, the micro fly's eye is the same as the fly's eye lens in that the lens elements having the positive refractive power are arranged vertically and laterally. In Fig. 1, for the purpose of clarification of the drawing, the minute lenses for constructing the micro fly's eye are depicted in a number which is extremely smaller than the actual number.

Therefore, the light beam, which comes into the micro fly's eye 6, is two-dimensionally divided by the large number of minute lenses. One group of light source including four spots is formed on the rear side focal plane of each of the minute lenses. As described above, the micro fly's eye 6 constitute a first optical integrator for forming a first multiple light source composed of a large number of light sources on the basis of the light beam coming from the light source 1.

The light beam from the large number of light sources formed on the rear, side focal plane of the micro fly's eye 6 illuminates, in a superimposed manner, a fly's eye lens 8 as a second optical integrator via a zoom lens (magnification-varying optical system) 7. The zoom lens is a magnification-varying optical system for varying the σ value in which the focal length can be continuously changed within a predetermined range. The zoom lens 7 optically connects the rear side focal plane of the micro fly's eye 6 and the rear side focal plane of the fly's eye lens 8 in a substantially conjugate manner. In other words, the zoom lens 7 connects the rear side focal plane of the micro fly's eye 6 and the light-incoming surface of the fly's eye lens 8 substantially in a relationship of Fourier transform.

Therefore, the light beam, which comes from the large number of four-spot light sources formed on the rear side focal plane of the micro fly's eye 6, forms a four-spot field composed of four illumination fields which are symmetrically eccentric with respect to the optical axis AX, on the rear side focal plane of the zoom lens 7, and consequently on the light-incoming surface of the fly's eye lens 8. The size of the quadrupole illumination field is changed depending on the focal length of the zoom lens 7. The focal length of the zoom lens 7 is changed by using a third driving system 24 which is operated on the basis of a command from the control system 21.

The fly's eye lens 8 is constructed such that a large number of lens elements having the positive refractive power are arranged densely in the vertical and lateral directions. Each of the respective lens elements for constructing the fly's eye lens 8 has a rectangular cross section which is similar to the shape of the illumination field to be formed on the mask (and consequently to the shape of the exposure area to be formed on the wafer). The surface of each of the lens elements for constructing the fly's eye lens 8, which is disposed on the light-incoming side, is formed to have a spherical configuration with its convex surface directed toward the light-incoming side, and the surface, which is disposed on the light-outgoing side, is formed to have a spherical configuration with its convex surface directed toward the light-outgoing side. Therefore, the light beam, which comes into the fly's eye lens 8, is divided two-dimensionally by the large number of lens elements. A large number of light sources are formed respectively on the rear side focal planes of the respective lens elements into which the light beam has come.

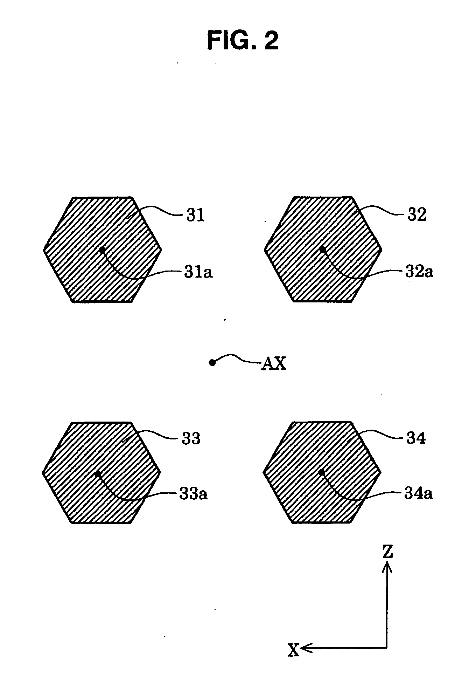

Accordingly, as shown in Fig. 2, a secondary light source, which has substantially the same light intensity distribution as that of the illumination field formed by the incoming light beam into the fly's eye lens 8, i.e., a quadrupole secondary light source substantially composed of four surface light sources 31 to 34 which are symmetrically eccentric with respect to the optical axis AX, is formed on the rear side focal plane of the fly's eye lens 8. As described above, the fly's eye lens 8 constitutes the second optical integrator for forming the second multiple light source composed of light sources of a larger number, on the basis of the light beam from the first multiple light source formed on the rear side focal plane of the micro fly's eye 6 as the first optical integrator.

The light beam, which comes from the quadrupole secondary light source formed on the rear side focal plane of the fly's eye lens 8, is restricted by an aperture diaphragm having a four-spot light-transmitting section, if necessary, and then the light beam is subjected to the light-collecting action of a condenser optical system 9. After that, the light beam illuminates, in a superimposed manner, the mask M on which a predetermined pattern is formed. The light beam, which has transmitted through the pattern on the mask M, forms an image of the mask pattern on the wafer W as a photosensitive substrate (a workpiece) by the aid of a projection optical system PL. In accordance with this procedure, the full field exposure or the scanning exposure is performed while two-dimensionally driving and controlling the wafer W in the plane (XY plane) perpendicular to the optical axis AX of the projection optical system PL. Thus, the respective exposure areas on the wafer W are successively exposed with the pattern on the mask M.

In the full field exposure, each of the exposure areas on the wafer is collectively exposed with the mask pattern in accordance with the so-called step-and-repeat system. In this case, the shape of the illumination area on the mask M is a rectangular configuration which is close to a square. The cross-sectional configuration of each of the lens elements of the fly's eye lens 8 is also a rectangular configuration which is close to a square. On the other hand, in the scanning exposure, each of the exposure areas on the wafer is subjected to scanning exposure with the mask pattern while relatively moving the mask and the wafer with respect to the projection optical system in accordance with the so-called step-and-scan system. In this case, the shape of the illumination area on the mask M is a rectangular configuration in which the ratio between the short side and the long side is, for example, 1:3. The cross-sectional configuration of each of the lens elements of the fly's eye lens 8 is also a rectangular configuration which is similar thereto.

With reference to Fig. 2 again, the quadrupole secondary light source, which is formed on the rear side focal plane of the fly's eye lens 8, is constructed by the four regular hexagonal surface light sources 31 to 34. In this case, the centers 31a to 34a of the respective surface light sources are separated from each other by the same distance from the optical axis AX. The quadrilateral, which is formed by connecting the four centers 31a to 34a, is a square which has sides parallel to the X direction and the Z direction about the center of the optical axis AX. That is, the quadrupole secondary light sources, which are formed by the fly's eye lens 8, are located in the same positional relationship concerning the X direction and the Z direction.

Therefore, the cross-sectional configuration of the light beam coming into an arbitrary one point on the mask M as the illumination objective plane also has a four-spot configuration having the same positional relationship concerning the X direction and the Z direction. In other words, the illumination condition is identical for the perpendicular two directions (X direction and Y direction) on the mask M. Accordingly, in the first embodiment, in order to realize mutually different illumination conditions in the perpendicular two directions on the mask M, a V-shaped axicon 10, which is composed of a pair of prisms 10a, 10b, is arranged in the optical path of the afocal zoom lens 5.

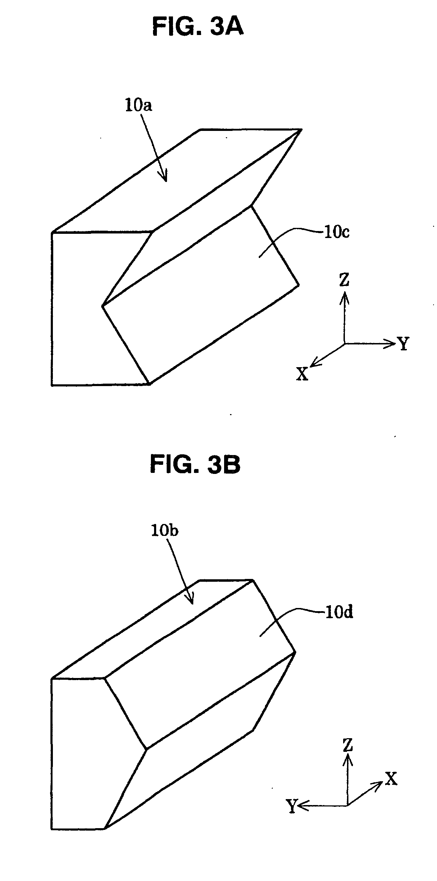

Fig. 3 schematically shows an arrangement of the pair of prisms for constructing a V-shaped axicon system (hereinafter simply referred to as "V-shaped axicon") arranged in the optical path of the afocal zoom lens. As shown in Figs. 1 and 3, the V-shaped axicon 10 comprises a first prism 10a which has a flat plane directed toward the light source and a concave refraction plane directed toward the illumination objective plane, and a second prism 10b which has a flat plane directed toward the illumination objective plane and a convex refraction plane directed toward the light source, the first prism 10a and the second prism 10b being arranged in this order from the side of the light source. The concave refraction plane 10c of the first prism 10a includes two flat surfaces which are parallel in the X direction, and it has a V-shaped convex cross section in the Z direction.

The convex refraction plane 10d of the second prism 10b is formed so that it is capable of making mutual abutment against the concave refraction plane 10c of the first prism 10a. In other words, the convex refraction plane 10d of the second prism 10b is formed complementarily with respect to the concave refraction plane 10c of the first prism 10a. That is, the concave refraction plane 10d of the second prism 10b is constructed by the two flat surfaces which are parallel in the X direction, having a V-shaped concave cross section in the Z direction. At least one of the first prism 10a and the second prism 10b is constructed to be movable along the optical axis AX. The spacing distance between the concave refraction plane 10c and the convex refraction plane 10d is constructed to be variable.

The change of the spacing distance of the V-shaped axicon 10, i.e., the change of the spacing distance between the concave refraction plane 10c and the convex refraction plane 10d is effected by a fourth driving system 25 which is operated on the basis of a command from the control system 21. For example, the information, which concerns a variety of masks to be successively exposed in accordance with the step-and-repeat system or the step-and-scan system, is inputted into the control system 21 by the aid of an input unit 20 such as a keyboard.

In this arrangement, the V-shaped axicon 10 functions as a plane parallel plate, and no influence is exerted on the quadrupole secondary light source to be formed, in a state in which the concave refraction plane 10c of the first prism 10a abuts against the convex refraction plane 10d of the second prism 10b. However, when the concave refraction plane 10c of the first prism 10a and the convex refraction plane 10d of the second prism 10b are separated from each other, then the V-shaped axicon 10 functions as a plane parallel plate in the X direction, but it functions as a beam expander in the Z direction.

Therefore, when the spacing distance between the concave refraction plane 10c and the convex refraction plane 10d is changed, then the angle of incidence of the incoming light beam into the micro fly's eye 6 in the X direction is not changed, but the angle of incidence of the incoming light beam into the micro fly's eye 6 in the Y direction is changed. As a result, the centers 31a to 34a of the respective surface light sources 31 to 34 shown in Fig. 2 are not moved in the X direction, but they are moved in the Z direction. In this way, the V-shaped axicon 10 constitutes an aspect ratio-changing element for changing the aspect ratio of the incoming light beam, because it changes the angle of incidence of the incoming light beam into the micro fly's eye 6 in the Y direction.

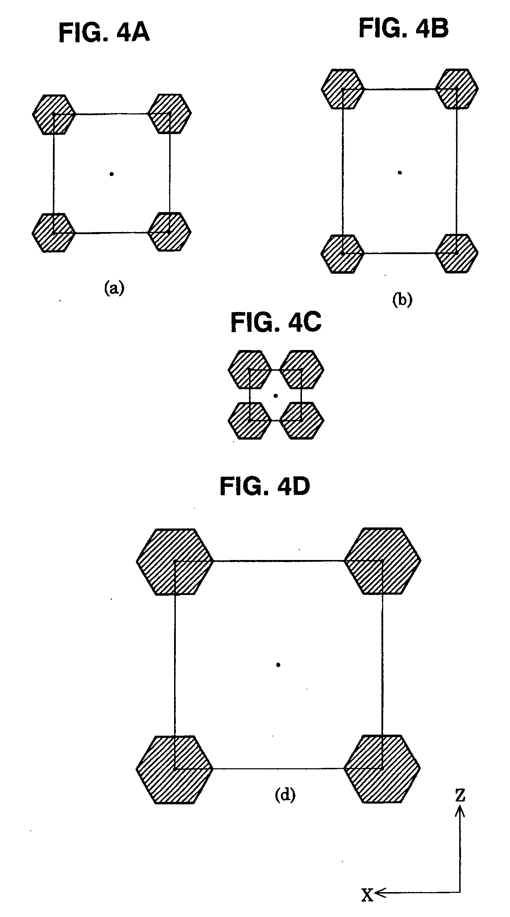

Fig. 4 schematically illustrates the influence exerted on the quadrupole secondary light source by the change of the spacing distance of the V-shaped axicon, the change of the magnification of the afocal zoom lens, and the change of the focal length of the zoom lens. As shown in Fig. 4A, when the spacing distance of the V-shaped axicon 10 is zero, i.e., when the concave refraction plane 10c abuts against the convex refraction plane 10d, then the respective surface light sources for constructing the quadrupole secondary light source are formed in the same positional relationship in relation to the X direction and the Z direction. When the spacing distance of the V-shaped axicon 10 is changed from zero to a predetermined size, then the respective surface light sources are moved in the Z direction without changing the shape and the size thereof as shown in Fig. 4B, and the spacing distance between the centers of the respective surface light sources in the X direction is not changed, but the spacing distance in the Z direction is increased.

When the magnification of the afocal zoom lens 5 is changed in the state in which the spacing distance of the V-shaped axicon 10 is zero, then the respective surface light sources are moved by the same distance in the X direction and the Z direction without changing the shape and the size thereof as shown in Fig. 4C, and the spacing distance between the respective surface light sources is increased or decreased. Further, when the focal length of the zoom lens 7 is changed in the state in which the spacing distance of the V-shaped axicon 10 is zero, the entire quadrupole secondary light source is similarly increased or decreased as shown in Fig. 4D. That is, the size of each of the surface light sources is increased or decreased without changing the shape thereof, and the respective surface light sources are moved by the same distance in the X direction and the Z direction. In order to avoid any deterioration of the prism members 10a, 10b which would be otherwise caused by the radiation of laser, it is preferable that the prism members 10a, 10b are arranged while being separated by a spacing distance from the light-collecting point at which the four spot images are formed in the optical path of the afocal zoom lens 5.

As described above, the diffracting optical element 4 is constructed insertably and detachably with respect to the illumination optical path. Further, the diffracting optical element 4 is exchangeable with the diffracting optical element 4a for the annular illumination or the diffracting optical element 4b for the conventional circular illumination. Brief description will be made below for the annular illumination obtained by setting the diffracting optical element 4a in the illumination optical path in place of the diffracting optical element 4.

When the diffracting optical element 4a for the annular illumination is set in the illumination optical path in place of the diffracting optical element 4 for the quadrupole illumination, an annular light beam is formed by the aid of the diffracting optical element 4a. The annular light beam, which is formed by the aid of the diffracting optical element 4a, comes into the afocal zoom lens 5 to form a ring-shaped image (ring-shaped light source) on the pupil plane. The light beam from the ring-shaped image forms a substantially parallel light beam to be radiated from the afocal zoom lens 5, and it forms a first multiple light source on the rear side focal plane of the micro fly's eye 6.

The light beam from the first multiple light source which is formed by the micro fly's eye 6 forms an annular illumination field about the center of the optical axis AX on the light-incoming surface of the fly's eye lens 8 by the aid of the zoom lens 7. As a result, a secondary light source which has substantially the same light intensity as that of the illumination field formed on the light-incoming surface, i.e., an annular secondary light source which is formed about the center of the optical axis AX is formed on the rear side focal plane of the fly's eye lens 8.

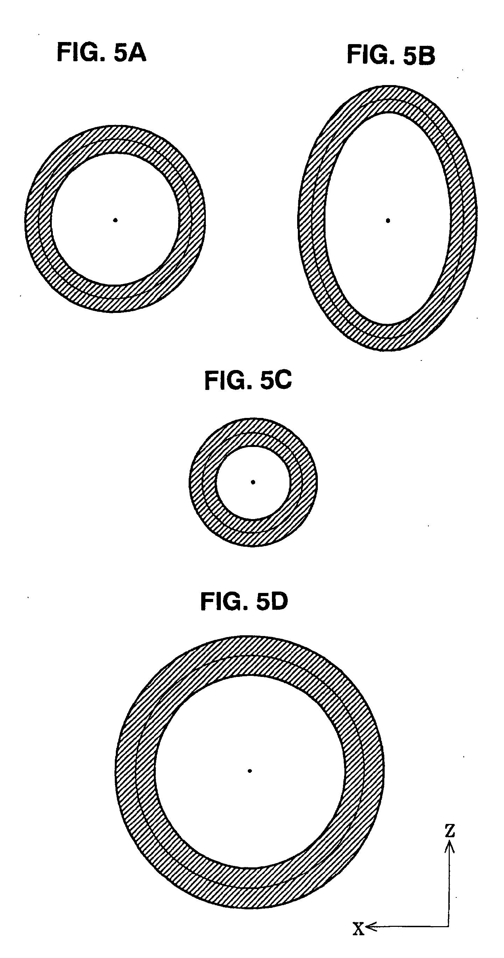

Fig. 5 schematically illustrates the influence exerted on the annular secondary light source by the change of the spacing distance of the V-shaped axicon, the change of the magnification of the afocal zoom lens, and the change of the focal length of the zoom lens. As shown in Fig. 5A, when the spacing distance of the V-shaped axicon 10 is zero, i.e., when the concave refraction plane 10c abuts against the convex refraction plane 10d, then the respective surface light sources for constructing the annular secondary light source are formed in the same positional relationship in relation to the X direction and the Z direction. When the spacing distance of the V-shaped axicon 10 is changed from zero to a predetermined size, then the entire size of the annular secondary light source is increased in the Z direction without changing the width of the annular secondary light source as shown in Fig. 5B to form an elliptic annular secondary light source extending in the Z direction.

When the magnification of the afocal zoom lens 5 is changed in the state in which the spacing distance of the V-shaped axicon 10 is zero, then the outer diameter (size) of the annular secondary light source is increased or decreased without changing the width thereof as shown in Fig. 5C. Further, when the focal length of the zoom lens 7 is changed in the state in which the spacing distance of the V-shaped axicon 10 is zero, the entire annular secondary light source is similarly increased or decreased as shown in Fig. 5D. That is, both of the width and the outer diameter of the annular secondary light source are increased or decreased.

Next, explanation will be made for the conventional circular illumination obtained by setting the diffracting optical element 4b for the circular illumination in the illumination optical path in place of the diffracting optical element 4 or 4a. The diffracting optical element 4b for the circular illumination has a function to convert the incoming rectangular light beam into a circular light beam. Therefore, the circular light beam, which is formed by the diffracting optical element 4b, is magnified or reduced by the afocal zoom lens 5 in accordance with the magnification thereof, and it comes into the micro fly's eye 6.

Accordingly, a first multiple light source is formed on the rear side focal plane of the micro fly's eye 6. The light beam from the first multiple light source which is formed on the rear side focal plane of the micro fly's eye 6 forms a circular illumination field about the center of the optical axis AX on the light-incoming surface of the fly's eye lens 8 by the aid of the zoom lens 7. As a result, a circular secondary light source, which is formed about the center of the optical axis AX, is also formed on the rear side focal plane of the fly's eye lens 8.

In this case, when the spacing distance of the V-shaped axicon 10 is changed from zero to a predetermined size, the circular secondary light source is enlarged in the Z direction to form an elliptic secondary light source extending in the Z direction. When the magnification of the afocal zoom lens 5 is changed, or when the focal length of the zoom lens 7 is changed in the state in which the spacing distance of the V-shaped axicon 10 is zero, then the entire circular secondary light source is similarly enlarged or reduced. That is, the outer diameter (size) of the circular secondary light source is magnified or reduced.

As described above, in the first embodiment, the entire size of the secondary light source is changed in the Z direction without being changed in the X direction by changing the spacing distance of the V-shaped axicon 10.
As a result, it is possible to realize the mutually different illumination conditions in the perpendicular two directions (X direction and Y direction) on the mask M. Consequently, it is possible to set the optimum illumination conditions in the perpendicular two directions on the mask M on which the pattern has the orientation.

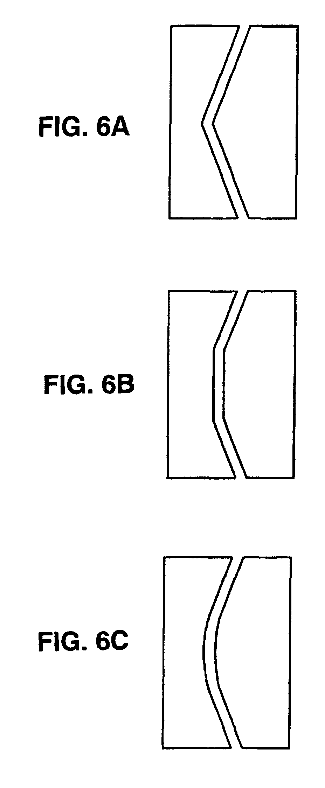

In the embodiment described above, as shown in Fig. 6A, the V-shaped axicon 10 is constructed by the first prism which has the V-shaped concave cross section and the second prism which has the V-shaped convex cross section. However, there is no limitation thereto. As shown in Fig. 6B, portions of the V-shaped concave cross section and the V-shaped convex cross section, which are disposed in the vicinity of the apexes, may be formed to have flat surface configurations perpendicular to the optical axis AX as well. Alternatively, in order to obtain an elliptic annular secondary light source or an elliptic secondary light source in which the contour is relatively smooth for the annular illumination or the circular illumination, it is preferable that portions of the V-shaped concave cross section and the V-shaped convex cross section, which are disposed in the vicinity of the apexes, are formed to have cylindrical configurations as shown in Fig. 6C.

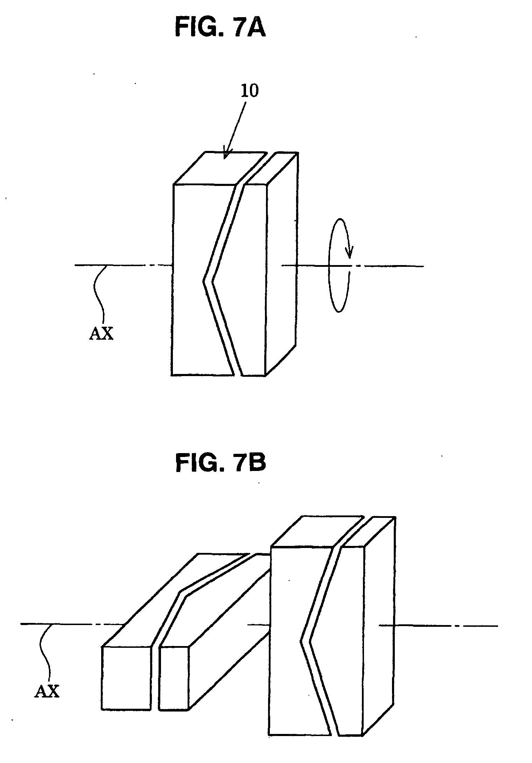

In the embodiment described above, the entire size of the secondary light source is changed in the Z direction without being changed in the X direction by changing the spacing distance of the V-shaped axicon 10. However, as shown in Fig. 7A, the V-shaped axicon 10 may be constructed to be rotatable about the center of the optical axis AX, and thus the entire size of the secondary light source may be changed in a desired direction (for example, in the X direction) as well.

Alternatively, as shown in Fig. 7B, the entire size of the secondary light source may be independently changed in the X direction and the Z direction respectively as well by arranging two pairs of V-shaped axicons in which the acting directions are perpendicular to one another. In this case, when the two pairs of the V-shaped axicons are constructed to be rotatable about the center of the optical axis AX integrally or independently, the entire size of the secondary light source may be independently changed in arbitrary perpendicular two directions or in arbitrary two directions respectively as well.

In the first embodiment described above, the diffracting optical elements 4, 4a, 4b as the light beam-converting elements may be also positioned in the illumination optical path, for example, in accordance with the turret system or by using the known slider mechanism.

In the first embodiment described above, the shape of the minute lens for constructing the micro fly's eye 6 is set to be regular hexagonal, for the following reason. That is, the regular hexagonal configuration is selected as a polygon which is close to a circle, because circular minute lenses cannot be arranged densely, resulting in occurrence of any light amount loss. However, the shape of each of the minute lenses for constructing the micro fly's eye 6 is not limited thereto. It is possible to use other appropriate shapes including, for example, rectangular shapes.

Further, in the first embodiment described above, the diffracting optical element 4b is positioned in the illumination optical path when the conventional circular illumination is performed. However, it is also possible to omit the use of the diffracting optical element 4b. Further, in the first embodiment described above, the diffracting optical element is used as the light beam-converting element. However, there is no limitation thereto. It is also possible to use, for example, a micro fly's eye or a minute prism array. Detailed explanation concerning the diffracting optical element capable of being used in the present invention is disclosed, for example, in United States Patent No. 5,850,300 and Japanese Patent Application Laid-open No. 2001-174615 (corresponding to United States Patent Application No.09/549,720 filed on April 14, 2000). The content of United States Patent No. 5,850,300 and Japanese Patent Application Laid-open No. 2001-174615 (corresponds to United States Patent Application No.09/549,720 ) is incorporated herein by reference.

The first embodiment described above is constructed such that the light beam from the secondary light source is collected by using the condenser optical system 9 to illuminate the mask M in the superimposed manner. However, an illumination field stop (mask blind) and a relay optical system for forming an image of the illumination field stop on the mask M may be arranged between the condenser optical system 9 and the mask M. In this case, the condenser optical system 9 collects the light from the secondary light source to illuminate the illumination field stop in a superimposed manner. The relay optical system forms the image of an aperture (light-transmitting section) of the illumination field stop on the mask M.

Further, in the first embodiment described above, the fly's eye lens 8 is formed by accumulating the plurality of element lenses. However, it is also possible that they are micro fly's eyes. As described above, the micro fly's eye is formed such that a plurality of minute lens surfaces are provided in a matrix configuration on a light-transmitting substrate by means of a technique such as etching. There is no substantial functional difference between the fly's eye lens and the micro fly's eye in relation to the fact that a plurality of light source images are formed. However, the micro fly's eye is advantageous, for example, because the size of the aperture of one element lens (minute lens) can be made extremely small, the production cost can be greatly reduced, and the thickness in the optical axis direction can be made extremely thin.

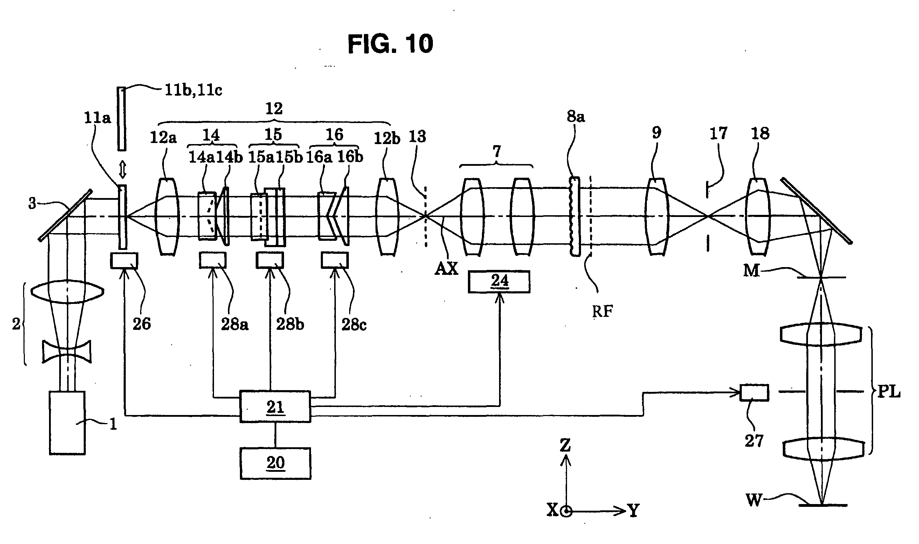

Fig. 10 schematically shows an arrangement of an exposure apparatus provided with an illumination optical apparatus according to a second embodiment of the present invention. The second embodiment is constructed similarly to the first embodiment. However, the former is basically different from the latter in the arrangement ranging from the bending mirror 3 to the zoom lens 7, the use of a micro fly's eye (micro lens array) 8a in place of the fly's eye lens 8, and the arrangement ranging from the condenser optical system 9 to the mask M. The second embodiment will be explained below while attracting the attention to the difference from the first embodiment. In Fig. 10, the illumination optical apparatus 4 is set to perform the quadrupole illumination.

In the second embodiment, the substantially parallel light beam, which is radiated from the light source 1, passes along the beam expander 2 and the bending mirror 3, and it comes into the diffracting optical element 11a for the quadrupole illumination. The diffracting optical element 11a has a function to form a four-spot light intensity distribution in the far field thereof (Fraunhofer diffraction area) when the parallel light beam having a rectangular cross section comes thereinto. The diffracting optical element 11a for the quadrupole illumination is constructed insertably and detachably with respect to the illumination optical path. The diffracting optical element 11a for the quadrupole illumination is exchangeable with the diffracting optical element 11b for the annular illumination or the diffracting optical element 11c for the circular illumination.

Specifically, the diffracting optical element 11a is supported on a turret substrate (rotary plate, not shown in Fig. 10) which is rotatable about a predetermined axis parallel to the optical axis AX. Those provided on the turret substrate in the circumferential direction are a plurality of diffracting optical elements 11a having different characteristics for the quadrupole illumination, a plurality of diffracting optical elements 11b having different characteristics for the annular illumination, and a plurality of diffracting optical elements 11c having different characteristics for the circular illumination. The turret substrate is rotatable about the axis which passes through the central point and which is parallel to the optical axis AX.

Therefore, a desired diffracting optical element, which is selected from the large number of diffracting optical elements 11a to 11c, can be positioned in the illumination optical path by rotating the turret substrate. The rotation of the turret substrate (and consequently the switching for the diffracting optical elements 11a, 11b) is performed by a driving system 26 which is operated on the basis of a command from the control system 21. However, there is no limitation to the turret system. For example, the switching for the diffracting optical elements 11a, 11b, 11c may be also performed in accordance with a known slide system.

The light beam, which has passed through the diffracting optical element 11a as a light shape converter, comes into an afocal lens (relay optical system) 12. The afocal lens 12 is an afocal system (afocal optical system) which is set so that the position of the front side focus position and the position of the diffracting optical element 11a are substantially coincident with each other, and the rear side focus position and the position of a predetermined plane 13 indicated by a broken line in the drawing are substantially coincident with each other. The position of the predetermined plane 13 corresponds to the position at which the micro fly's eye 6 is installed in the first embodiment.

Therefore, the substantially parallel light beam, which comes into the diffracting optical element 11a, forms the four-spot light intensity distribution on the pupil plane of the afocal lens 12, and then it forms a substantially parallel light beam to be radiated from the afocal lens 12. A conical axicon 14, a first V-shaped axicon 15, and a second V-shaped axicon 16 are arranged in this order from the side of the light source in the optical path between a front side lens group 12a and a rear side lens group 12b of the afocal lens 12. Detailed arrangement and function of these components will be described later on. Basic arrangement and function of the second embodiment will be described below while omitting the function of the axicons 14 to 16 in order to simplify the description.

The light beam, which has passed through the afocal lens 12, comes into a micro fly's eye 8a as an optical integrator via a zoom lens (magnification-varying optical system) 7 for varying the σ value. The σ value is defined as σ = NAi/NAo = R2/R1 provided that R1 represents the size (diameter) of the pupil of the projection optical system PL, R2 represents the size (diameter) of the illumination light beam or the light source image formed on the pupil of the projection optical system PL, NAo represents the numerical aperture on the side of the mask (reticle) M of the projection optical system PL, and NAi represents the numerical aperture of the illumination optical system for illuminating the mask (reticle) M. However, in the case of the annular illumination, R2 represents the outer diameter of the annular illumination light beam or the annular light source image which is formed on the pupil of the projection optical system PL, and NAi represents the numerical aperture which is determined by the outer diameter of the annular light beam formed on the pupil of the illumination optical system. In the case of the quadrupole illumination or the like, R2 represents the size or the diameter of the circle which circumscribes the multiple-spot illumination light beam or the multiple-spot light source image formed on the pupil of the projection optical system PL, and NAi represents the numerical aperture which is determined by the size or the diameter of the circle circumscribing the multiple-spot illumination light beam formed on the pupil of the illumination optical system. In the case of the annular illumination, the annular ratio is defined by Ri/Ro provided that Ro represents the outer diameter of the annular illumination light beam, and Ri represents the inner diameter of the annular illumination light beam.

The predetermined plane 13 is arranged at the position in the vicinity of the front side focus position of the zoom lens 7. The light-incoming surface of the micro fly's eye 8 is arranged in the vicinity of the rear side focus position of the zoom lens 7. In other words, the zoom lens 7 serves to arrange the predetermined plane 13 and the light-incoming surface of the micro fly's eye 8a substantially in a relationship of Fourier transform, and consequently arrange the pupil plane of the afocal lens 12 and the light-incoming surface of the micro fly's eye 8a optically substantially in a conjugate manner. Therefore, a quadrupole illumination field, which is composed of, for example, four illumination fields eccentric with respect to the optical axis AX, is formed on the light-incoming surface of the micro fly's eye 8a which has the same function as that of the fly's eye lens 8 in the first embodiment, in the same manner as for the pupil plane of the afocal lens 12. The shape of each of the illumination fields for constructing the quadrupole illumination field depends on the characteristic of the diffracting optical element 11a. However, in this case, it is assumed that the quadrupole illumination field, which is composed of four circular illumination fields, is formed. The entire shape of the quadrupole illumination field is changed similarly depending on the focal length of the zoom lens 7.

Each of the minute lenses for constructing the micro fly's eye 8a has a rectangular cross section which is similar to the shape of the illumination field to be formed on the mask M (and consequently the shape of the exposure area to be formed on the wafer W). The light beam, which has come into the micro fly's eye 8a, is two-dimensionally divided by the large number of minute lenses to form, on the rear side focal plane (and consequently on the pupil of the illumination optical system), the secondary light source having substantially the same light intensity distribution as that of the illumination field to be formed by the light beam coming into the micro fly's eye 8a, i.e., the quadrupole secondary light source composed of four circular substantial surface light sources eccentric with respect to the optical axis AX.

The light beam, which comes from the quadrupole secondary light source formed on the rear side focal plane of the micro fly's eye 8a, is subjected to the light-collecting action of the condenser optical system 9, and then it illuminates, in a superimposed manner, a mask blind 17 as an illumination field stop. The light beam, which has passed through the rectangular aperture (light-transmitting section) of the mask blind 17, is subjected to the light-collecting action of an image-forming optical system 18, and then it illuminates the mask M in a superimposed manner. The light beam, which has passed through a pattern on the mask M, forms an image of the mask pattern on the wafer W by the aid of the projection optical system PL. A variable aperture diaphragm for defining the numerical aperture of the projection optical system PL is provided in the projection optical system PL. The pupil of projection optical system PL is positioned at a position of the image of the variable aperture diaphragm. The variable aperture diaphragm is driven by a driving system 27 which is operated on the basis of a command from the control system 21.

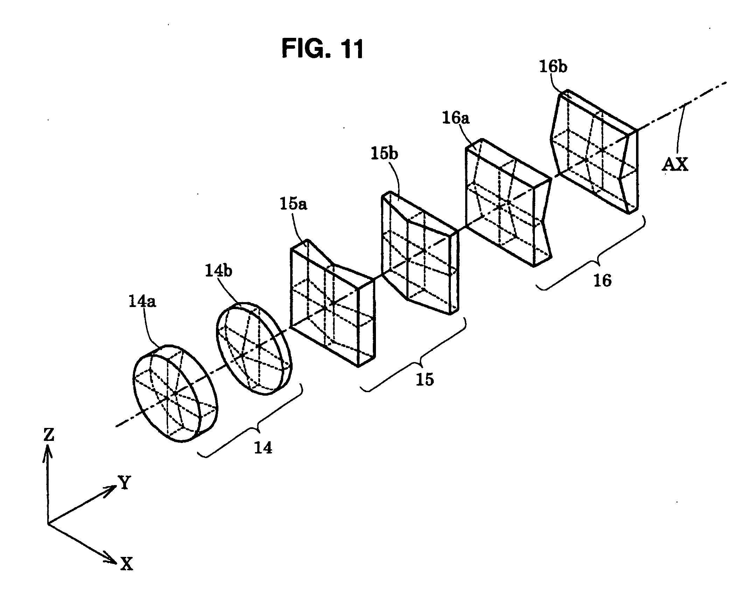

Fig. 11 shows a perspective view schematically illustrating an arrangement of three axicon systems (hereinafter simply referred to as "axicons") which are arranged in the optical path between the front side lens group and the rear side lens group of the afocal lens in the second embodiment. In the second embodiment, as shown in Fig. 11, the conical axicon 14, the first V-shaped axicon 15, and the second V-shaped axicon 16 are arranged in this order from the side of the light source in the optical path between the front side lens group 12a and the rear side lens group 12b of the afocal lens 12.

The conical axicon 14 comprises a first prism member 14a which has a flat plane directed toward the light source and a concave cone-shaped refraction surface directed toward the mask, and a second prism member 14b which has a flat plane directed toward the mask and a convex cone-shaped refraction surface directed toward the light source, the first prism member 14a and the second prism member 14b being arranged in this order from the side of the light source. The concave cone-shaped refraction surface of the first prism member 14a and the convex cone-shaped refraction surface of the second prism member 14b are formed complementarily so that they are capable of making mutual abutment.

At least one member of the first prism member 14a and the second prism member 14b is constructed to be movable along the optical axis AX. The spacing distance between the concave cone-shaped refraction surface of the first prism member 14a and the convex cone-shaped refraction surface of the second prism member 14b is variable. The spacing distance of the conical axicon 14 is changed by a driving system 28a which is operated on the basis of a command from the control system 21.

In this arrangement, the conical axicon 14 functions as a plane parallel plate in a state in which the concave cone-shaped refraction surface of the first prism member 14a abuts against the convex cone-shaped refraction surface of the second prism member 14b. No influence is exerted on the quadrupole secondary light source to be formed. However, when the concave cone-shaped refraction surface of the first prism member 14a is separated from the convex cone-shaped refraction surface of the second prism member 14b, the conical axicon 14 functions as a so-called beam expander. Therefore, the angle of the incoming light beam into the predetermined plane 13 is changed in accordance with the change of the spacing distance of the conical axicon 14.

The first V-shaped axicon 15 comprises a first prism member 15a which has a flat plane directed toward the light source and a concave refraction plane having a V-shaped configuration directed toward the mask, and a second prism member 15b which has a flat plane directed toward the mask and a convex refraction plane having a V-shaped configuration directed toward the light source. The concave refraction plane of the first prism member 15a includes two flat surfaces with a line of intersection thereof extending in the Z direction. The convex refraction plane of the second prism member 15b is formed to make mutual abutment against the convex refraction plane of the first prism member 15a. In other words, the convex refraction plane of the second prism member 15b is formed complementarily with the concave refraction plane of the first prism member 15a.

That is, the convex refraction plane of the second prism member 15b also includes two flat surfaces with a line of intersection thereof extending in the Z direction. At least one of the first prism member 15a and the second prism member 15b is constructed to be movable along the optical axis AX. The spacing distance between the concave refraction plane of the first prism member 15a and the convex refraction plane of the second prism member 15b is variable. The spacing distance of the first V-shaped axicon 15 is changed by a driving system 28b which is operated on the basis of a command from the control system 21.

The second V-shaped axicon 16 comprises a first prism member 16a which has a flat plane directed toward the light source and a concave refraction plane having a V-shaped configuration directed toward the mask, and a second prism member 16b which has a flat plane directed toward the mask and a convex refraction plane having a V-shaped configuration directed toward the light source. The concave refraction plane of the first prism member 16a includes two flat surfaces with a line of intersection thereof extending in the X direction. The convex refraction plane of the second prism member 16b is formed complementarily with the concave refraction plane of the first prism member 16a. That is, the convex refraction plane of the second prism member 16b also includes two flat surfaces with a line of intersection thereof extending in the X direction.

At least one of the first prism member 16a and the second prism member 16b is constructed to be movable along the optical axis AX. The spacing distance between the concave refraction plane of the first prism member 16a and the convex refraction plane of the second prism member 16b is variable. The spacing distance of the second V-shaped axicon 16 is changed by a driving system 28c which is operated on the basis of a command from the control system 21.

In this arrangement, in a state in which the concave refraction plane and the convex refraction plane, which are opposed to one another, make mutual abutment, each of the first V-shaped axicon 15 and the second V-shaped axicon 16 functions as a plane parallel plate, and no influence is exerted on the quadrupole secondary light source to be formed. However, when the concave refraction plane and the convex refraction plane are separated from each other, then the first V-shaped axicon 15 functions as a plane parallel plate in the Z direction, but it functions as a beam expander in the X direction. When the concave refraction plane and the convex refraction plane are separated from each other, then the second V-shaped axicon 16 functions as a plane parallel plate in the X direction, but it functions as a beam expander in the Z direction.

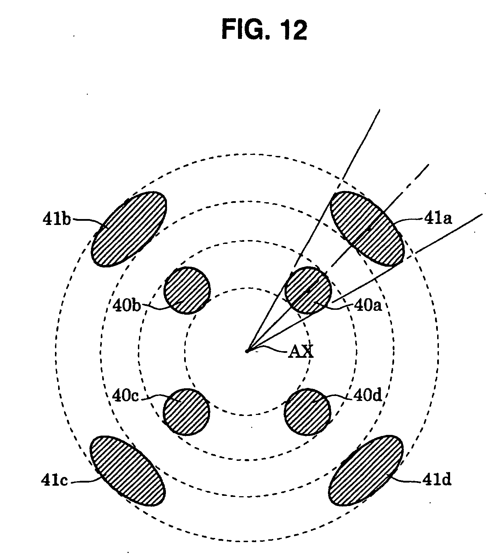

Fig. 12 illustrates the function of the conical axicon for the secondary light source formed by the quadrupole illumination in the second embodiment. In the quadrupole illumination in the second embodiment, when the spacing distance of the conical axicon 14 is enlarged from zero to a predetermined value, then each of the circular surface light sources 40a to 40d for constructing the quadrupole secondary light source is moved outwardly in the radial direction of the center formed about the center of the optical axis AX, and the shape is changed from the circular configuration to the elliptic configuration. That is, the line segment, which connects the central point of each of the circular surface light sources 40a to 40d before the change and the central point of each of the elliptic surface light sources 41a to 41d after the change, passes through the optical axis AX, and the distance of movement of the central point depends on the spacing distance of the conical axicon 14.

Further, the angle, at which each of the circular surface light sources 40a to 40d before the change is viewed from the optical axis AX (angle formed by a pair of tangential lines extending from the optical axis AX to the respective surface light sources 40a to 40d) is equal to the angle at which each of the elliptic surface light sources 41a to 41d after the change is viewed from the optical axis AX. The diameter of each of the circular surface light sources 40a to 40d before the change is equal to the short diameter of each of the elliptic surface light sources 41a to 41d after the change in the radial direction of the circle formed about the center of the optical axis AX. The size of the long diameter of each of the elliptic surface light sources 41a to 41d after the change, which is disposed in the circumferential direction of the circle formed about the center of the optical axis AX, depends on the diameter of each of the circular surface light sources 40a to 40d before the change and the spacing distance of the conical axicon 14.

Therefore, when the spacing distance of the conical axicon 14 is increased from zero to a predetermined value, then the quadrupole secondary light source, which is constructed by the four circular surface light sources, is changed into the quadrupole secondary light source constructed by the four elliptic surface light sources, and thus the outer diameter and the annular ratio can be changed without changing the width of the secondary light source before the change. In this case, the width of the quadrupole secondary light source is defined as 1/2 of the difference between the diameter of the circle circumscribing the four surface light sources, i.e., the outer diameter and the diameter of the circle inscribing the four surface light sources, i.e., the inner diameter. The annular ratio of the quadrupole secondary light source is defined as the ratio of the inner diameter to the outer diameter (inner diameter/outer diameter).

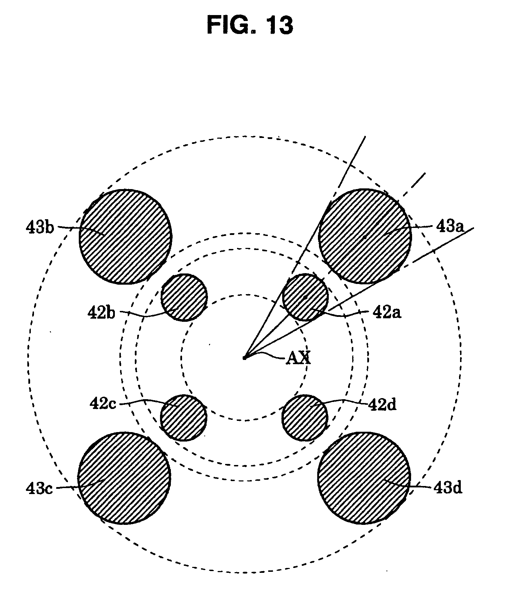

Fig. 13 illustrates the function of the zoom lens for the secondary light source formed by the quadrupole illumination in the second embodiment. In the quadrupole illumination in the second embodiment, when the focal length of the zoom lens 7 is changed, the entire shape of the quadrupole secondary light source, which is constructed by the four circular surface light sources 42a to 42d, is similarly changed. That is, the respective circular surface light sources 42a to 42d for constructing the quadrupole secondary light source are moved in the radial directions of the circle formed about the center of the optical axis AX while maintaining the circular configuration.

The line segment, which connects the central point of each of the surface light sources 42a to 42d before the change and the central point of each of the surface light sources 43a to 43d after the change, passes through the optical axis AX, and the distance of movement and the direction of movement of the central point depend on the change of the focal length of the zoom lens 7. Further, the angle, at which each of the surface light sources 42a to 42d before the change is viewed from the optical axis AX is equal to the angle at which each of the surface light sources 43a to 43d after the change is viewed from the optical axis AX. Accordingly, only the outer diameter of the quadrupole secondary light source can be changed by changing the focal length of the zoom lens 7 without changing the annular ratio of the quadrupole secondary light source.

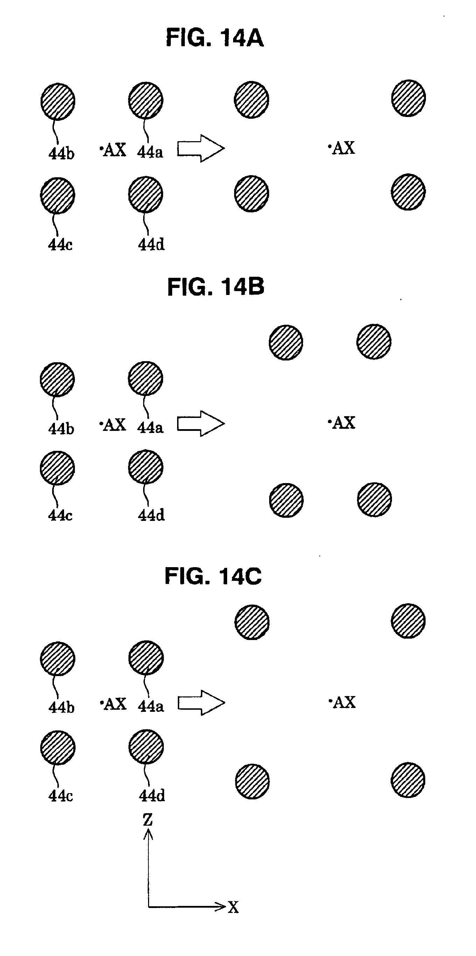

Fig. 14 illustrates the function of the first V-shaped axicon and the second V-shaped axicon for the secondary light source formed by the quadrupole illumination in the second embodiment. When the spacing distance of the first V-shaped axicon 15 is changed, then the angle of incidence of the incoming light beam into the predetermined plane 13 in the Z direction is not changed, but the angle of incidence of the incoming light beam into the predetermined plane 13 in the X direction is changed. As a result, as shown in Fig. 14A, the four circular surface light sources 44a to 44d are not moved in the Z direction, but they are moved in the X direction while maintaining the shape and the size thereof. That is, when the spacing distance of the first V-shaped axicon 15 is increased from zero to a predetermined value, then the surface light sources 44b, 44c are moved in the -X direction, and the surface light sources 44a, 44d are moved in the +X direction.

On the other hand, when the spacing distance of the second v-shaped axicon 16 is changed, the angle of incidence of the incoming light beam into the predetermined plane 13 in the X direction is not changed, but the angle of incidence of the incoming light beam into the predetermined plane 13 in the Z direction is changed. As a result, as shown in Fig. 14B, the four circular surface light sources 44a to 44d are not moved in the X direction, but they are moved in the Z direction while maintaining the shape and the size thereof. That is, when the spacing distance of the second V-shaped axicon 16 is increased from zero to a predetermined value, then the surface light sources 44a, 44b are moved in the +Z direction, and the surface light sources 44c, 44d are moved in the -Z direction.

When both of the spacing distance of the first V-shaped axicon 15 and the spacing distance of the second V-shaped axicon 16 are changed, both of the angle of incidence of the incoming light beam into the predetermined plane 13 in the X direction and the angle of incidence of the incoming light beam into the predetermined plane 13 in the Z direction are changed. As a result, as shown in Fig. 14C, the respective four circular surface light sources 44a to 44d are moved in the Z direction and in the X direction while maintaining the shape and the size thereof. That is, when both of the spacing distance of the first V-shaped axicon 15 and the spacing distance of the second V-shaped axicon 16 are increased from zero to the predetermined values, then the surface light source 44a is moved in the +Z direction and in the +X direction, the surface light source 44b is moved in the +Z direction and in the -X direction, the surface light source 44c is moved in the -Z direction and in the -X direction, and the surface light source 44d is moved in the -Z direction and in the +X direction.

As described above, the conical axicon 14 constitutes an annular ratio-varying unit for varying the annular ratio of the illumination light beam on the pupil of the illumination optical system (on the rear side focal plane RF of the micro fly's eye 8a). The zoom lens 7 constitutes a magnification-varying optical system for varying the magnitude of the illumination light beam on the pupil of the illumination optical system. The first V-shaped axicon 15 constitutes a first displacing unit for symmetrically displacing the illumination light beam on the pupil of the illumination optical system with respect to the optical axis in the X direction. The second V-shaped axicon 16 constitutes a second displacing unit for symmetrically displacing the illumination light beam on the pupil of the illumination optical system with respect to the optical axis in the Z direction. The conical axicon 14, the first V-shaped axicon 15, the second V-shaped axicon 16, and the zoom lens 17 constitute a varying mechanism for varying the magnitude and the shape of the illumination light beam on the pupil of the illumination optical system.

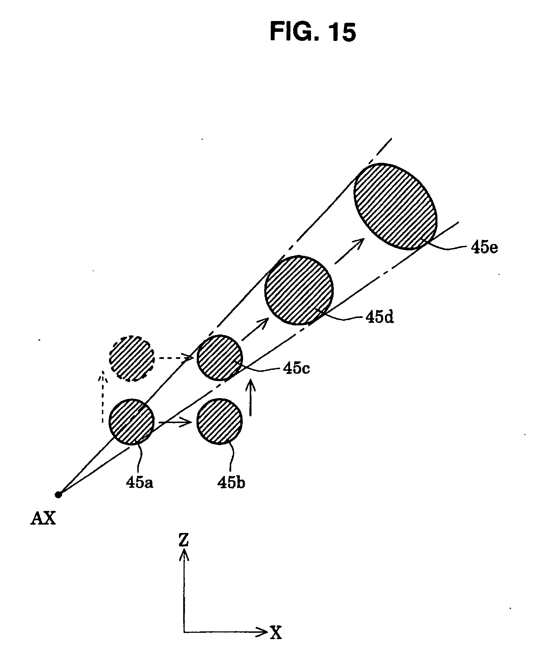

Fig. 15 illustrates the function of the conical axicon, the zoom lens, the first V-shaped axicon, and the second V-shaped axicon for the respective circular surface light sources formed by the quadrupole illumination in the second embodiment. In Fig. 15, the attention is paid to one surface light source 45a of the four circular surface light sources for constructing the smallest quadrupole secondary light source formed in a state (hereinafter referred to as "standard state") in which all of the spacing distances of the conical axicon 14, the first V-shaped axicon 15, and the second V-shaped axicon 16 are zero, and the focal length of the zoom lens 7 is set to the minimum value.

Starting from the standard state, when the spacing distance of the first V-shaped axicon 15 is increased from zero to a predetermined value, then the surface light source 45a is moved in the X direction while maintaining the shape and the size thereof, and it arrives at a position indicated by reference numeral 45b. Subsequently, when the spacing distance of the second V-shaped axicon 16 is increased from zero to a predetermined value, then the surface light source 45b is moved in the z direction while maintaining the shape and the size thereof, and it arrives at a position indicated by reference numeral 45c.

When the focal length of the zoom lens 7 is increased from the minimum value to a predetermined value, then the circular surface light source 45c is enlarged while maintaining the circular configuration, it is moved outwardly in the radial direction of the circle formed about the center of the optical axis AX, and it arrives at a position indicated by reference numeral 45d. Further, if necessary, when the spacing distance of the conical axicon 14 is increased from zero to a predetermined value, then the circular surface light source 45d is changed from the circular configuration to an enlarged elliptic configuration, it is moved outwardly in the radial direction of the circle formed about the center of the optical axis AX, and it arrives at a position indicated by reference numeral 45e.

Even when the spacing distance of the first V-shaped axicon 15 is increased from zero to a predetermined value after the spacing distance of the second V-shaped axicon 16 is increased from zero to a predetermined value, the surface light source 45a arrives at the position indicated by reference numeral 45c while maintaining the shape and the size thereof. Similarly, the position, the shape, and the size of the surface light source, which are finally obtained, depend on the change of the spacing distances of the conical axicon 14, the first V-shaped axicon 15, and the second V-shaped axicon 16 and the change of the focal length of the zoom lens 7, and they do not depend on the order of the changes.

Accordingly, the positions of the respective surface light sources for constructing the quadrupole secondary light source can be moved over the wide range owing to the function of the conical axicon 14, the first V-shaped axicon 15, the second V-shaped axicon 16, and the zoom lens 7. Further, it is possible to change the shape and the size thereof over the predetermined range. However, actually, the movement ratio of each of the surface light sources (i.e., the coordinate position of the surface light source before the movement with respect to the coordinate position of the surface light source after the movement), which is brought about by the conical axicon 14, the first V-shaped axicon 15, and the second V-shaped axicon 16, is restricted due to the optical design. Further, the range of the movement of each of the surface light sources is limited.

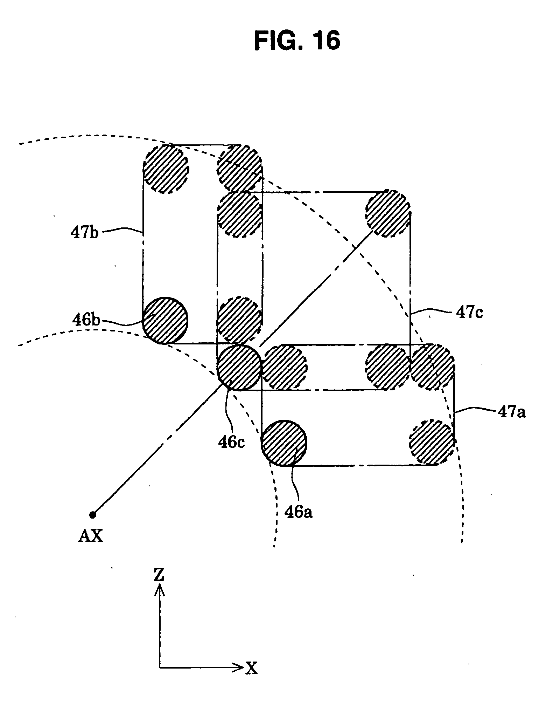

Accordingly, in the second embodiment, three types of diffracting optical elements having different characteristics are provided as the diffracting optical element 11a for the quadrupole illumination. Fig. 16 illustrates the respective surface light sources and the movement ranges of the respective surface light sources which are formed by the aid of the three types of the diffracting optical elements for the quadrupole illumination having the different characteristics in the second embodiment. Also in Fig. 16, the attention is paid to one surface light source 46 of the four circular surface light sources for constructing the smallest quadrupole secondary light source formed in the standard state, in the same manner as in Fig. 15.

In the second embodiment, the first diffracting optical element for the quadrupole illumination is used to form a quadrupole secondary light source in which the quadrangle formed by connecting the central points of four surface light sources is a rectangle which is slender in the X direction, i.e., a quadrupole secondary light source as shown in the right half of Fig. 14A. One surface light source 46a of the four circular surface light sources for constructing the quadrupole secondary light source formed by the first diffracting optical element for the quadrupole illumination is moved within a rectangular range indicated by reference numeral 47a in accordance with the action of the first V-shaped axicon 15 and the second V-shaped axicon 16.

On the other hand, the second diffracting optical element for the quadrupole illumination is used to form a quadrupole secondary light source in which the quadrangle formed by connecting the central points of four surface light sources is a rectangle which is slender in the Z direction, i.e., a quadrupole secondary light source as shown in the right half of Fig. 14B. One surface light source 46b of the four circular surface light sources for constructing the quadrupole secondary light source formed by the second diffracting optical element for the quadrupole illumination is moved within a rectangular range indicated by reference numeral 47b in accordance with the action of the first V-shaped axicon 15 and the second V-shaped axicon 16.

Further, the third diffracting optical element for the quadrupole illumination is used to form a quadrupole secondary light source in which the quadrangle formed by connecting the central points of four surface light sources is a square, i.e., a quadrupole secondary light source as shown in the right half of Fig. 14C (or in the left halves of Figs. 14A to 14C). One surface light source 46c of the four circular surface light sources for constructing the quadrupole secondary light source formed by the third diffracting optical element for the quadrupole illumination is moved within a rectangular range indicated by reference numeral 47c in accordance with the action of the first v-shaped axicon 15 and the second V-shaped axicon 16.

Accordingly, in the second embodiment, even when the movement ratio (and consequently the movement range) of each of the surface light sources brought about by the first V-shaped axicon 15 and the second V-shaped axicon 16 is restricted to some extent in view of the optical design, it is possible to freely move the position of each of the surface light sources in the annular area about the center of the optical axis AX by using the three type of the diffracting optical elements for the quadrupole illumination having the different characteristics in combination. Although not shown in Fig. 16, it is also possible to appropriately change the position, the shape, and the size of each of the surface light sources to be in a desired state in the annular area formed about the center of the optical axis AX owing to the function of the conical axicon 14 and the zoom lens 7.

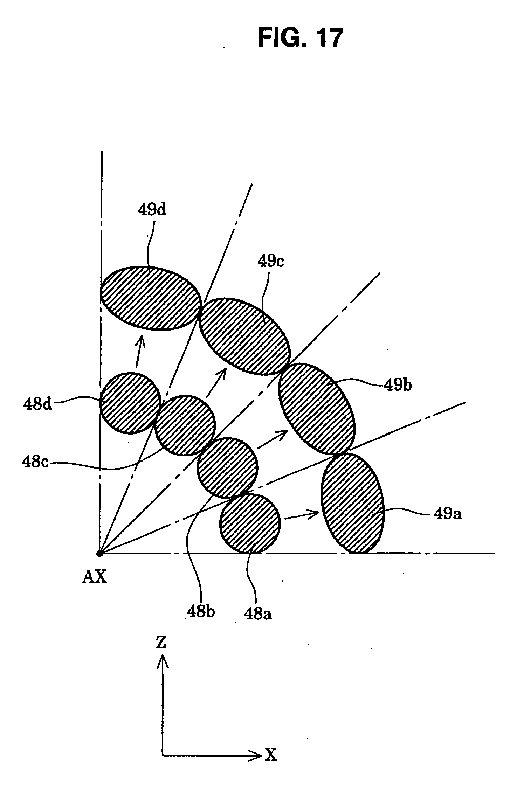

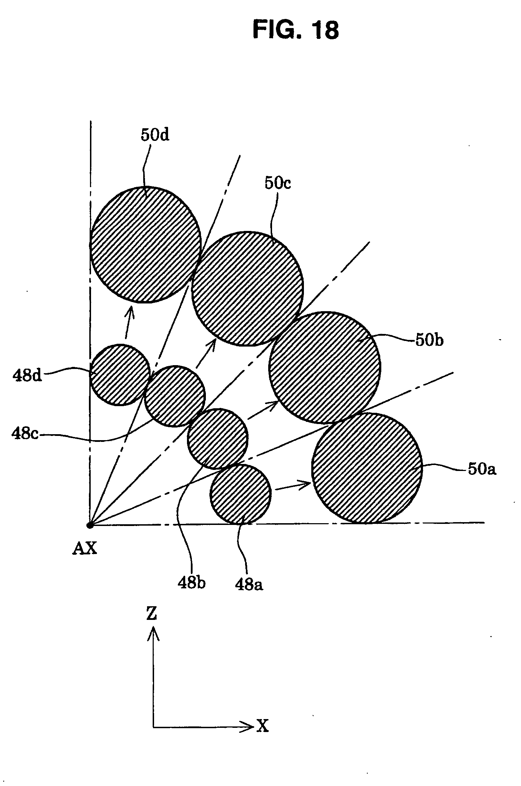

A first modification of the second embodiment is provided with four types of diffracting optical elements having different characteristics as the diffracting optical element 11a for the quadrupole illumination. Figs. 17 and 18 illustrate respective surface light sources, the movement thereof, and the deformation thereof, the respective surface light sources being formed by the four types of the diffracting optical elements for the quadrupole illumination having the different characteristics in the first modification of the second embodiment. Also in Figs. 17 and 18, the attention is paid to one surface light source 48 of the four circular surface light sources for constructing the smallest quadrupole secondary light source formed in the standard state, in the same manner as in Figs. 15 and 16.

In the first modification of the second embodiment, as shown in Figs. 17 and 18, the quarter-circular area, which is defined by the circle formed about the center of the optical axis AX, the line segment parallel to the X axis, and the line segment parallel to the Z axis, is divided into four sector areas by the three line segments which pass through the optical axis AX. The centers of the respective circular surface light sources 48a to 48d, which are formed by the four types of the diffracting optical elements for the quadrupole illumination respectively, are set to be located in the respective sector areas. That is, the setting is made as follows. The surface light source 48a is formed by the first diffracting optical element, the surface light source 48b is formed by the second diffracting optical element, the surface light source 48c is formed by the third diffracting optical element, and the surface light source 48d is formed by the fourth diffracting optical element.

In the following description, in order to simplify the explanation, it is assumed that the quarter-circular area is equally divided into the four sector areas, and the respective surface light sources 48a to 48d are arranged in the circumferential direction of the circle formed about the center of the optical axis AX so that the respective surface light sources 48a to 48d make contact with each other. In this arrangement, when the spacing distance of the conical axicon 14 is increased from zero to a predetermined value, then the respective surface light sources 48a to 48d are changed so that the shape thereof is altered from the circle to the enlarged ellipse as shown in Fig. 17, and their central positions are moved outwardly in the radial direction of the circle formed about the center of the optical axis AX to arrive at positions indicated by reference numerals 49a to 49d respectively.

When the focal length of the zoom lens 7 is increased from the minimum value to a predetermined value, the respective surface light sources 48a to 48d are enlarged while maintaining the circular configuration as shown in Fig. 18, and their central positions are moved outwardly in the radial direction of the circle formed about the center of the optical axis AX to arrive at positions indicated by reference numerals 50a to 50d respectively. Accordingly, in the firstmodification of the second embodiment, the position, the shape, and the size of each of the surface light sources can be freely changed in the annular area formed about the center of the optical axis AX by using the four types of the diffracting optical elements for the quadrupole illumination having the different characteristics in combination.

In Figs. 17 and 18, the respective surface light sources 48a to 48d are arranged so that they make contact with each other. However, it is also possible to arrange the respective surface light sources 48a to 48d so that they are separated from each other by spacing distances. In any case, the position, the shape, and the size of each of the surface light sources can be appropriately changed into those in a desired state in the circular annular area formed about the center of the optical axis AX owing to the function of the conical axicon 14, the first V-shaped axicon 15, the second V-shaped axicon 16, and the zoom lens 7.

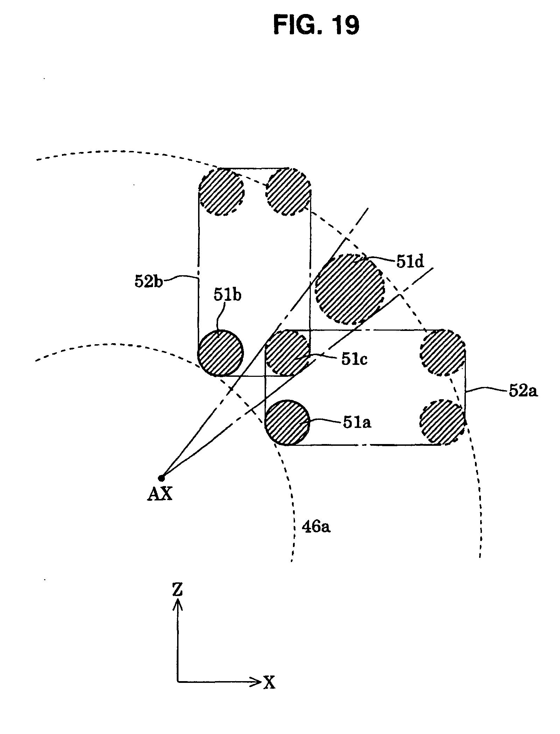

Further, a second modification of the second embodiment is provided with two types of diffracting optical elements having different characteristics as the diffracting optical element 11a for the quadrupole illumination. Fig. 19 illustrates the respective surface light sources, the movement thereof, and the deformation thereof, the respective surface light sources being formed by the aid of the two types of the diffracting optical elements for the quadrupole illumination having the different characteristics in the second modification of the second embodiment. Also in Fig. 19, the attention is paid to one surface light source 51 of the four circular surface light sources for constructing the smallest quadrupole secondary light source formed in the standard state, in the same manner as in Figs. 15 to 18.

In the second modification of the second embodiment, the first diffracting optical element for the quadrupole illumination is used to form the quadrupole secondary light source in which the quadrangle formed by connecting the central points of the four surface light sources is a rectangle which is slender in the X direction. One surface light source 51a (corresponding to 46a in Fig. 16) of the four circular surface light sources for constructing the quadrupole secondary light source formed by the first diffracting optical element for the quadrupole illumination is movable within the rectangular range indicated by reference numeral 52a in accordance with the action of the first V-shaped axicon 15 and the second V-shaped axicon 16.

On the other hand, the second diffracting optical element for the quadrupole illumination is used to form the quadrupole secondary light source in which the quadrangle formed by connecting the central points of the four surface light sources is a rectangle which is slender in the Z direction. One surface light source 51b (corresponding to 46b in Fig. 16) of the four circular surface light sources for constructing the quadrupole secondary light source formed by the second diffracting optical element for the quadrupole illumination is movable within the rectangular range indicated by reference numeral 52b in accordance with the action of the first V-shaped axicon 15 and the second V-shaped axicon 16.

Further, when the first diffracting optical element for the quadrupole illumination and the second V-shaped axicon 16 are used in combination, or when the second diffracting optical element for the quadrupole illumination and the first V-shaped axicon 15 are used in combination, then the surface light source 51c is formed at an intermediate position between the initial surface light sources 51a, 51b. In this case, when the magnification-varying function of the zoom lens 7 is effected for the surface light source 51c, then the surface light source 51c is enlarged while maintaining the circular configuration thereof, and the central position is moved outwardly in the radial direction of the circle formed about the center of the optical axis AX to arrive at the position indicated by reference numeral 51d.

Although not shown in the drawing, when the conical axicon 14 is allowed to act on the surface light source 51c, then the circular configuration of the surface light source 51c is changed to an enlarged elliptic configuration, and the central position is moved outwardly in the radial direction of the circle formed about the center of the optical axis AX. Accordingly, in the second modification of the second embodiment, the position of each of the surface light sources can be freely moved in the circular annular area formed about the center of the optical axis AX by using the two types of the diffracting optical elements for the quadrupole illumination having the different characteristics. In general, the position, the shape, and the size of each of the surface light sources can be appropriately changed into those in a desired state in the circular annular area formed about the center of the optical axis AX in accordance with the action of the conical axicon 14, the first V-shaped axicon 15, the second V-shaped axicon 16, and the zoom lens 7.

Next, brief explanation will be made for the annular illumination obtained by setting the diffracting optical element 11b for the annular illumination in the illumination optical path in place of the diffracting optical element 11a for the quadrupole illumination. In this case, the substantially parallel light beam, which comes into the diffracting optical element 11b, forms an annular light intensity distribution on the pupil plane of the afocal lens 12, and then it forms a substantially parallel light beam which outgoes from the afocal lens 12. The light beam, which has passed through the afocal lens 12, is transmitted through the zoom lens 7 to form an annular illumination field formed about the center of the optical axis AX on the light-incoming surface of the micro fly's eye 8a. As a result, the secondary light source, which has substantially the same light intensity distribution as that of the illumination field formed by the incoming light beam, i.e., the annular secondary light source formed about the center of the optical axis AX is formed on the rear side focal plane of the micro fly's eye 8a.

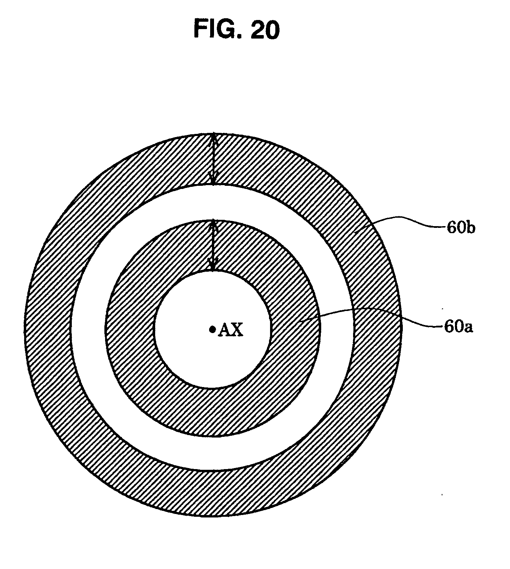

Fig. 20 illustrates the function of the conical axicon for the secondary light source formed by the annular illumination in the second embodiment. In the annular illumination in the second embodiment, the smallest annular secondary light source 60a, which is formed in the standard state, is changed to the annular secondary light source 60b in which both of the outer diameter and the inner diameter are enlarged without changing the width (1/2 of the difference between the outer diameter and the inner diameter as indicated by arrows in the drawing) by increasing the spacing distance of the conical axicon 14 from zero to a predetermined value. In other words, both of the annular ratio and the size (outer diameter) of the annular secondary light source are changed without changing the width in accordance with the action of the conical axicon 14.

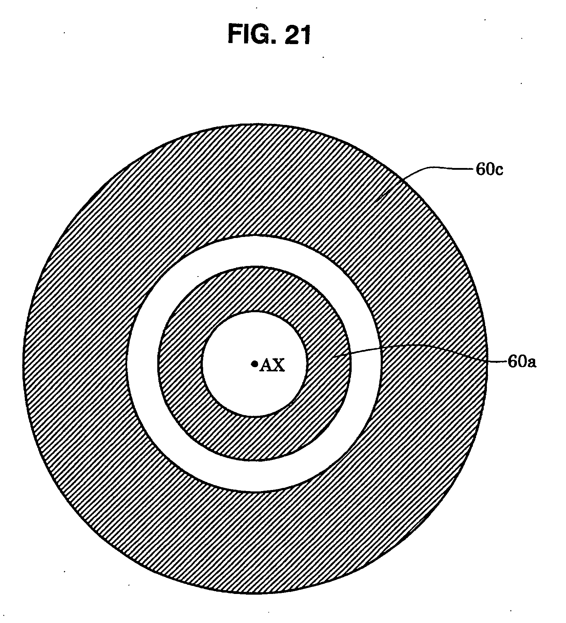

Fig. 21 illustrates the function of the zoom lens for the secondary light source formed in the annular illumination in the second embodiment. In the annular illumination in the second embodiment, the annular secondary light source 60a, which is formed in the standard state, is changed to the annular secondary light source 60c in which the entire shape is similarly enlarged, by increasing the focal length of the zoom lens 7 from the minimum value to a predetermined value. In other words, both of the width and the size (outer diameter) of the annular secondary light source are changed without changing the annular ratio in accordance with the action of the zoom lens 7.

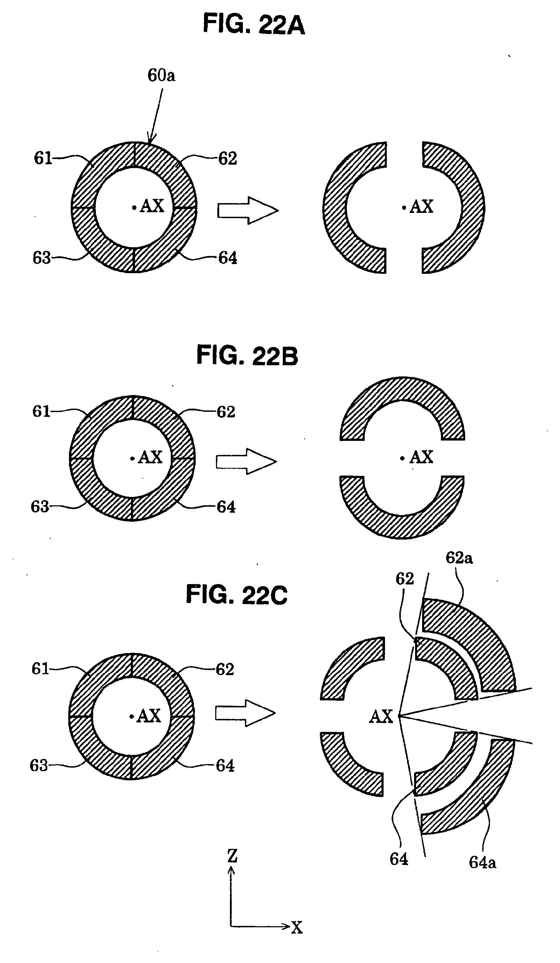

Fig. 22 illustrates the function of the first V-shaped axicon and the second V-shaped axicon for the secondary light source formed in the annular illumination in the second embodiment. As described above, when the spacing distance of the first V-shaped axicon 15 is changed, then the angle of incidence of the incoming light beam into the predetermined plane 13 in the Z direction is not changed, but the angle of incidence of the incoming light beam into the predetermined plane 13 in the X direction is changed. As a result, as shown in Fig. 22A, the respective four quarter-circular surface light sources 61 to 64, which constitute the annular secondary light source 60a, are not moved in the Z direction, but they are moved in the X direction. That is, when the spacing distance of the first V-shaped axicon 15 is increased from zero to a predetermined value, then the surface light sources 61, 63 are moved in the -X direction, and the surface light sources 62, 64 are moved in the +X direction.

On the other hand, when the spacing distance of the second V-shaped axicon 16 is changed, then the angle of incidence of the incoming-light beam into the predetermined plane 13 in the X direction is not changed, but the angle of incidence of the incoming-light beam into the predetermined plane 13 in the Z direction is changed. As a result, as shown in Fig. 22B, the respective surface light sources 61 to 64 are not moved in the X direction, but they are moved in the Z direction. That is, when the spacing distance of the second V-shaped axicon 16 is increased from zero to a predetermined value, then the surface light sources 61, 62 are moved in the +Z direction, and the surface light sources 63, 64 are moved in the -Z direction.

Further, when both of the spacing distance of the first V-shaped axicon 15 and the spacing distance of the second V-shaped axicon 16 are changed, both of the angle of incidence of the incoming-light beam into the predetermined plane 13 in the X direction and the angle of incidence in the Z direction are changed. As a result, as shown in Fig. 22C, the respective surface light sources 61 to 64 are moved in the Z direction and the X direction. That is, when the spacing distance of the first V-shaped axicon 15 and the spacing distance of the second V-shaped axicon 16 are increased from zero to predetermined values, then the surface light source 61 is moved in the +Z direction and the -X direction, the surface light source 62 is moved in the +Z direction and the +X direction, the surface light source 63 is moved in the -Z direction and the -X direction, and the surface light source 64 is moved in the -Z direction and the +X direction. Accordingly, it is possible to form the quadrupole secondary light source composed of the four independent surface light sources each having the circular arc-shaped configuration.

In the foregoing description, the function of each of the conical axicon 14, the first V-shaped axicon 15, the second V-shaped axicon 16, and the zoom lens 7 has been individually explained in the annular illumination in the second embodiment. However, it is possible to effect the annular illumination in a variety of forms in accordance with the interaction of these optical members. Specifically, when the zoom lens 7 is allowed to act in the state shown in Fig. 22C, for example, then the surface light source 62 is moved in the radial direction of the circle formed about the center of the optical axis AX, and it is changed into the surface light source 62 in which the entire shape is similarly changed. On the other hand, when the conical axicon 14 is allowed to act in the state shown in Fig. 22C, for example, then the surface light source 64 is moved in the radial direction of the circle formed about the center of the optical axis AX, and it is changed into the surface light source 64a in which only the size in the circumferential direction is changed without changing the size in the radial direction.

However, actually, due to the restriction of the optical design, there is a certain limit for the range of the change of the annular ratio effected by the conical axicon 14. Accordingly, the second embodiment is provided with the two types of the diffracting optical elements having the different characteristics as the diffracting optical element 11b for the annular illumination. That is, in the second embodiment, the first diffracting optical element for the annular illumination is used to form the annular secondary light source having the shape which is appropriate to change the annular ratio, for example, within a range of 0.5 to 0.68. On the other hand, the second diffracting optical element for the annular illumination is used to form the annular secondary light source having the shape which is appropriate to change the annular ratio, for example, within a range of 0.68 to 0.8. As a result, when the two types of the diffracting optical elements for the annular illumination are used in combination, it is possible to change the annular ratio within a range of 0.5 to 0.8.

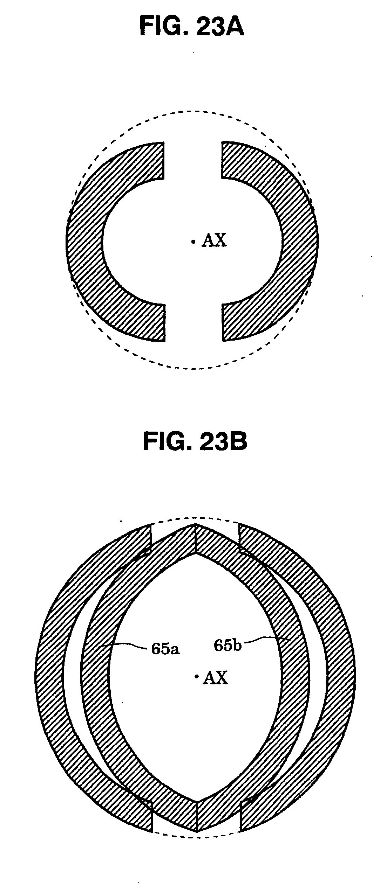

With reference to Fig. 23A, it is understood that the curvature of the circle (indicated by a broken line in the drawing), which circumscribes the two-spot secondary light source obtained in the right half of Fig. 22A or Fig. 22B, is not coincident with the curvature of the outer circular arc of each of the surface light sources having the semicircular arc-shaped configuration. Accordingly, in a third modification of the second embodiment, in order to allow the curvature of the circle circumscribing the two-spot secondary light source obtained by the action of the first V-shaped axicon 15 or the second V-shaped axicon 16 to coincide with the curvature of the outer circular arc of each of the surface light sources having the semicircular arc-shaped configuration, a third diffracting optical element for the annular illumination is additionally provided. As shown in Fig. 23B, the third diffracting optical element for the annular illumination forms an elliptic annular secondary light source which is slightly flat in the X direction or the Z direction, without forming a completely annular secondary light source as defined by two circles formed about the center of the optical axis AX.

In particular, the elliptic annular secondary light source, which is formed by the third diffracting optical element for the annular illumination, is constructed by a pair of circular arc-shaped surface light sources 65a, 65b. The curvature of the outer circular arc of each of the surface light sources 65a, 65b is set to coincide with the curvature of the circle which circumscribes the two-spot secondary light source obtained by the action of the first V-shaped axicon 15 or the second V-shaped axicon 16. Therefore, in the third modification of the second embodiment, the curvature of the circle, which circumscribes the two-spot secondary light source, is coincident with the curvature of the outer circular arc of each of the circular arc-shaped surface light sources 65a, 65b in the two-spot secondary light source obtained by the action of the first V-shaped axicon 15 or the second V-shaped axicon 16.

Further, brief explanation will be made for the conventional circular illumination obtained by setting the diffracting optical element 11c for the circular illumination in the illumination optical path in place of the diffracting optical element 11a for the quadrupole illumination or the diffracting optical element 11b for the annular illumination. In this case, the substantially parallel light beam, which comes into the diffracting optical element 11c, forms the circular light intensity distribution on the pupil plane of the afocal lens 12, and then it forms the substantially parallel light beam outgoing from the afocal lens 12.

The light beam, which has passed through the afocal lens 12, forms a circular illumination field formed about the center of the optical axis AX on the light-incoming surface of the micro fly's eye 8a by the aid of the zoom lens 7. As a result, the secondary light source, which has approximately the same light intensity distribution as that of the illumination field formed by the incoming light beam, i.e., the circular secondary light source formed about the center of the optical axis AX, is formed on the rear side focal plane of the micro fly's eye 8a (i.e., on the pupil of the illumination optical system).

In the circular illumination in the second embodiment, the smallest circular secondary light source formed in the standard state is changed into the circular secondary light source in which the entire shape is similarly enlarged by increasing the focal length of the zoom lens 7 from the minimum value to a predetermined value. In other words, in the circular illumination in the second embodiment, the size (outer diameter) of the circular secondary light source can be changed by changing the focal length of the zoom lens 7.

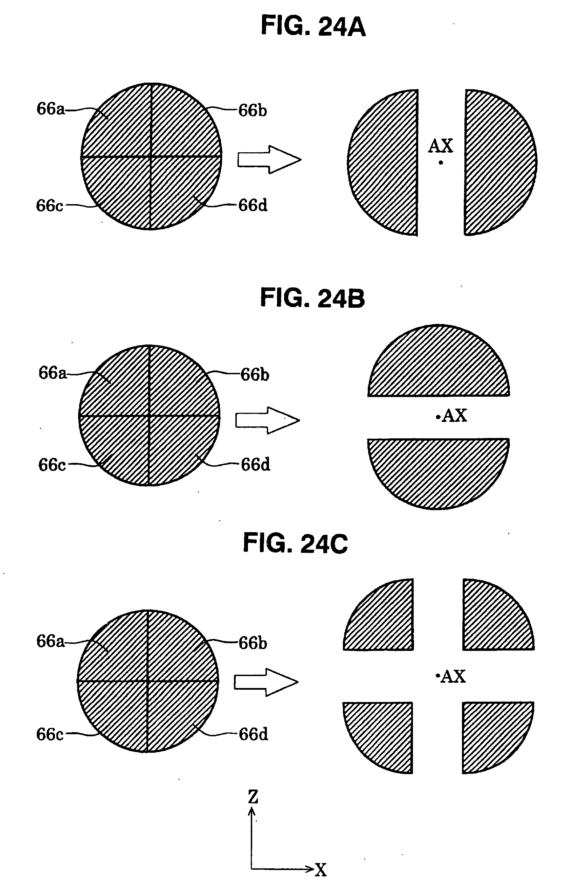

Fig. 24 illustrates the function of the first V-shaped axicon and the second V-shaped axicon for the secondary light source formed in the circular illumination in the second embodiment. In the circular illumination in the second embodiment, when the spacing distance of the first V-shaped axicon 15 is increased from zero to a predetermined value, then the surface light sources 66a, 66c, which are included in the four quarter-circular surface light sources 66a to 66d for constructing the circular secondary light source, are moved in the -x direction, and the surface light sources 66b, 66d are moved in the +X direction as shown in Fig. 24A.

On the other hand, when the spacing distance of the second V-shaped axicon 16 is increased from zero to a predetermined value, then the surface light sources 66a, 66b are moved in the +Z direction, and the surface light sources 66c, 66d are moved in the -Z direction as shown in Fig. 24B. Further, when both of the spacing distance of the first V-shaped axicon 15 and the spacing distance of the second V-shaped axicon 16 are increased from zero to predetermined values, the surface light source 66a is moved in the +Z direction and the -X direction, the surface light source 66b is moved in the +Z direction and the +X direction, the surface light source 66c is moved in the -Z direction and the -X direction, and the surface light source 66d is moved in the -Z direction and the +X direction as shown in Fig. 24C. Accordingly, it is possible to form the quadrupole secondary light source composed of the four independent quarter-circular surface light sources.

In the foregoing description, the function has been individually explained for each of the first V-shaped axicon 15, the second V-shaped axicon 16, and the zoom lens 7 in the circular illumination in the second embodiment. The circular illumination can be effected in a variety of forms in accordance with the interaction of these optical members. However, actually, the magnification-varying range of the outer diameter, which is effected by the zoom lens 7, is limited due to the restriction in view of the optical design. Accordingly, the second embodiment is provided with the two types of the diffracting optical elements having the different characteristics as the diffracting optical element 11c for the circular illumination.

That is, in the second embodiment, the first diffracting optical element for the circular illumination is used to form the circular secondary light source having the shape which is appropriate to change the σ value within a range from a relatively small σ value, i.e., small σ to an intermediate σ value, i.e., middle σ. Further, the second diffracting optical element for the circular illumination is used to form the circular secondary light source having the shape which is appropriate to change the σ value within a range from the middle σ to a relatively large σ value, i.e., large σ. As a result, when the two types of the diffracting optical elements for the circular illumination are used in combination, it is possible to change the σ value within a range from the small σ to the large σ (for example, 0.1 ≤ *σ* ≤ 0.95).

The operation for switching the illumination condition in the second embodiment and other operations will be specifically explained below. At first, for example, the information, which concerns a variety of masks to be successively exposed in accordance with the step-and-repeat system or the step-and-scan system, is inputted into the control system 21 by the aid of an input unit 20 such as a keyboard. The control system 21 stores, in an internal memory section, the information concerning, for example, the optimum line width (resolution) and the depth of focus in relation to the various masks. The control system 21 supplies appropriate control signals to the driving systems 24, 26 to 28 in response to the input from the input unit 20.

That is, when the quadrupole illumination is performed with the optimum resolution and the optimum depth of focus, the driving system 26 positions the diffracting optical element 11a for the quadrupole illumination in the illumination optical path on the basis of the command from the control system 21. In order to obtain the quadrupole secondary light source having a desired form, the driving systems 28a to 28c set the spacing distances of the axicons 14 to 16 on the basis of the commands from the control system 21. The driving system 24 sets the focal length of the zoom lens 7 on the basis of the command from the control system 21. Further, the driving system 27 drives the variable aperture diaphragm of the projection optical system PL on the basis of the command from the control system 21.

Further, if necessary, the form of the quadrupole secondary light source formed on the rear side focal plane of the micro fly's eye 8a can be appropriately changed by changing the spacing distances of the axicons 14 to 16 by the aid of the driving systems 28a to 28c and/or by changing the focal length of the zoom lens 7 by the aid of the driving system 24. Accordingly, it is possible to perform the quadrupole illumination in various ways by appropriately changing, for example, the entire size (outer diameter) and the shape (annular ratio) of the quadrupole secondary light source as well as the position, the shape, and the size of each of the surface light sources.

When the annular illumination is performed with the optimum resolution and the optimum depth of focus, the driving system 26 positions the diffracting optical element 11b for the annular illumination in the illumination optical path on the basis of the command from the control system 21. In order to obtain the annular secondary light source having a desired form, or in order to obtain the quadrupole secondary light source or the two-spot secondary light source derivatively obtained from the annular secondary light source, the driving systems 28a to 28c set the spacing distances of the axicons 14 to 16 on the basis of the commands from the control system 21. The driving system 24 sets the focal length of the zoom lens 7 on the basis of the command from the control system 21. Further, the driving system 27 drives the variable aperture diaphragm of the projection optical system PL on the basis of the command from the control system 21.

Further, if necessary, the form of the annular secondary light source formed on the rear side focal plane of the micro fly's eye 8a or the form of the quadrupole secondary light source or the two-spot secondary light source derivatively obtained can be appropriately changed by changing the spacing distances of the axicons 14 to 16 by the aid of the driving systems 28a to 28c and/or by changing the focal length of the zoom lens 7 by the aid of the driving system 24. Accordingly, it is possible to perform the annular illumination in various ways by appropriately changing, for example, the entire size (outer diameter) and the shape (annular ratio) of the annular secondary light source as well as the position, the shape, and the size of each of the surface light sources derivatively obtained.

When the conventional circular illumination is performed with the optimum resolution and the optimum depth of focus, the driving system 26 positions the diffracting optical element 11c for the circular illumination in the illumination optical path on the basis of the command from the control system 21. In order to obtain the circular secondary light source having a desired form, or in order to obtain the quadrupole secondary light source or the two-spot secondary light source derivatively obtained from the circular secondary light source, the driving systems 28a to 28c set the spacing distances of the axicons 14 to 16 on the basis of the commands from the control system 21. The driving system 24 sets the focal length of the zoom lens 7 on the basis of the command from the control system 21. Further, the driving system 27 drives the variable aperture diaphragm of the projection optical system PL on the basis of the command from the control system 21.

Further, if necessary, the form of the circular secondary light source formed on the rear side focal plane of the micro fly's eye 8a or the form of the quadrupole secondary light source or the two-spot secondary light source derivatively obtained can be appropriately changed by changing the spacing distances of the axicons 14 to 16 by the aid of the driving systems 28a to 28c and/or by changing the focal length of the zoom lens 7 by the aid of the driving system 24. Accordingly, it is possible to perform the circular illumination in various ways by appropriately changing, for example, the entire size (consequently the σ value) of the circular secondary light source as well as the position, the shape, and the size of each of the surface light sources derivatively obtained.

In the second embodiment, the conical axicon 14, the first V-shaped axicon 15, and the second V-shaped axicon 16 are arranged in this order from the side of the light source. However, the order of arrangement may be appropriately changed. As for each of the axicons 14 to 16, the first prism member having the concave refraction plane and the second prism member having the convex refraction plane are arranged in this order from the side of the light source. However, the order of arrangement may be inverted.

In the second embodiment, each of the axicons 14 to 16 is constructed by the pair of prism members. However, there is no limitation thereto. For example, the second prism member 14b of the conical axicon 14 and the first prism member 15a of the first V-shaped axicon 15 may be integrated into one unit, and/or the second prism member 15b of the first V-shaped axicon 15 and the first prism member 16a of the second V-shaped axicon 16 may be integrated into one unit. In this arrangement, the spacing distance of each of the axicons 14 to 16 can be changed independently from each other by moving, along the optical axis AX, at least three members of the first prism member 14a of the conical axicon 14, the integrated two prisms, and the second prism member 16b of the second V-shaped axicon 16.

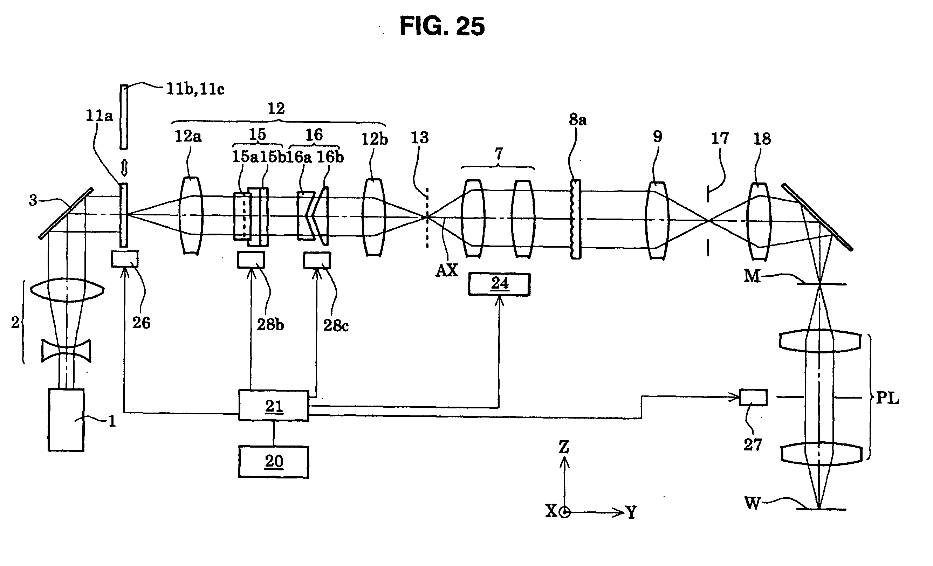

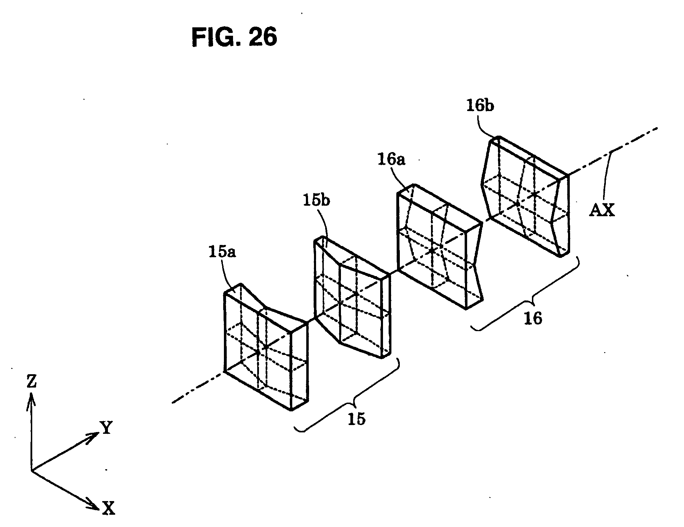

Fig. 25 schematically shows an arrangement of an exposure apparatus provided with an illumination optical apparatus according to a third embodiment of the present invention. Fig. 26 shows a perspective view schematically illustrating an arrangement of a pair of V-shaped axicons arranged in an optical path of an afocal lens in the third embodiment. The third embodiment is constructed similarly to the second embodiment. However, in the second embodiment, the conical axicon and the pair of V-shaped axicons are arranged in the optical path of the afocal lens 12. On the contrary, the third embodiment is basically different from the second embodiment in that only the pair of V-shaped axicons are arranged. The third embodiment will be explained below while paying the attention to the difference from the second embodiment.

In the quadrupole illumination in the third embodiment, the conical axicon is not arranged. Therefore, the circular configuration of each of the surface light sources for constructing the quadrupole secondary light source cannot be changed into the elliptic configuration. However, the position of each of the surface light sources can be appropriately changed in a circular annular area formed about the center of the optical axis AX by selectively using a plurality of diffracting optical elements 11a for the quadrupole illumination and utilizing the function of the first V-shaped axicon 15 and the second v-shaped axicon 16. Further, the position and the size of each of the surface light sources can be appropriately changed in a circular annular area formed about the center of the optical axis AX by utilizing the magnification-varying function of the zoom lens 7 in an auxiliary manner.

On the other hand, in the annular illumination in the third embodiment, the annular ratio of the annular secondary light source cannot be changed continuously, because no conical axicon is arranged. However, it is possible to appropriately change the entire size and the shape (annular ratio) of the annular secondary light source or the position, the shape, and the size of each of the surface light sources for constructing the two-spot secondary light source or the quadrupole secondary light source derivatively obtained from the annular secondary light source, by selectively using a plurality of diffracting optical elements 11b for the annular illumination and utilizing the function of the first V-shaped axicon 15, the second V-shaped axicon 16, and the zoom lens 7.

In the circular illumination, the function of the conical axicon is not used progressively. Therefore, also in the circular illumination in the third embodiment, it is possible to appropriately change the entire size of the circular secondary light source, or the position, the shape, and the size of each of the surface light sources for constructing the two-spot secondary light source or the quadrupole secondary light source derivatively obtained from the circular secondary light source, in the same manner as in the second embodiment.

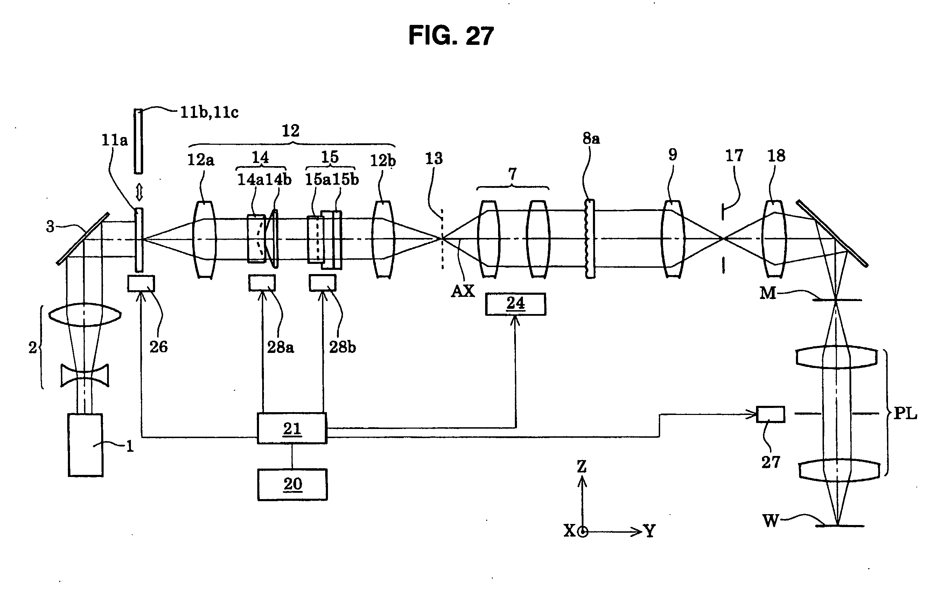

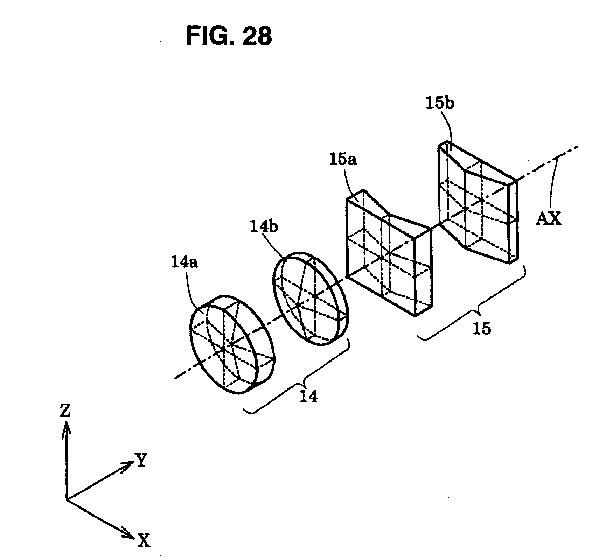

Fig. 27 schematically shows an arrangement of an exposure apparatus provided with an illumination optical apparatus according to a fourth embodiment of the present invention. Fig. 28 shows a perspective view schematically illustrating a conical axicon and a first V-shaped axicon arranged in an optical path of an afocal lens in the fourth embodiment. The fourth embodiment is constructed similarly to the second embodiment. However, in the second embodiment, the conical axicon and the pair of V-shaped axicons are arranged in the optical path of the afocal lens 12. On the contrary, the fourth embodiment is basically different from the second embodiment in that only the conical axicon and the first V-shaped axicon are arranged. The fourth embodiment will be explained below while paying the attention to the difference from the second embodiment. In Figs. 27 and 28, the first V-shaped axicon 15 is shown as one V-shaped axicon. However, one V-shaped axicon may be the second V-shaped axicon 16.

In the quadrupole illumination in the fourth embodiment, only one V-shaped axicon (15 or 16) is arranged. Therefore, it is impossible to two-dimensionally change only the position while maintaining the shape and the size of each of the circular surface light sources for constructing the quadrupole secondary light source. However, the position, the shape, and the size of each of the surface light sources can be appropriately changed in a circular annular area formed about the center of the optical axis AX by selectively using a plurality of diffracting optical elements 11a for the quadrupole illumination and utilizing the function of the conical axicon 14, the one V-shaped axicon (15 or 16), and the zoom lens 7.

On the other hand, in the annular illumination in the fourth embodiment, it is impossible to obtain the quadrupole secondary light source derivatively from the annular secondary light source, because only the one V-shaped axicon (15 or 16) is arranged. However, it is possible to appropriately change the entire size and the shape (annular ratio) of the annular secondary light source or the position, the shape, and the size of each of the surface light sources for constructing the two-spot secondary light source derivatively obtained from the annular secondary light source, by selectively using a plurality of diffracting optical elements 11b for the annular illumination and utilizing the function of the conical axicon 14, the one V-shaped axicon (15 or 16), and the zoom lens 7.

Further, in the circular illumination in the fourth embodiment, it is impossible to obtain the quadrupole secondary light source derivatively from the circular secondary light source, because only one V-shaped axicon (15 or 16) is arranged. However, it is possible to appropriately change the entire size of the circular secondary light source, or the position, the shape, and the size of each of the surface light sources for constructing the two-spot secondary light source derivatively obtained from the circular secondary light source, by selectively using the plurality of diffracting optical elements 11c for the circular illumination and utilizing the function of the conical axicon 14, the one V-shaped axicon (15 or 16), and the zoom lens 7.

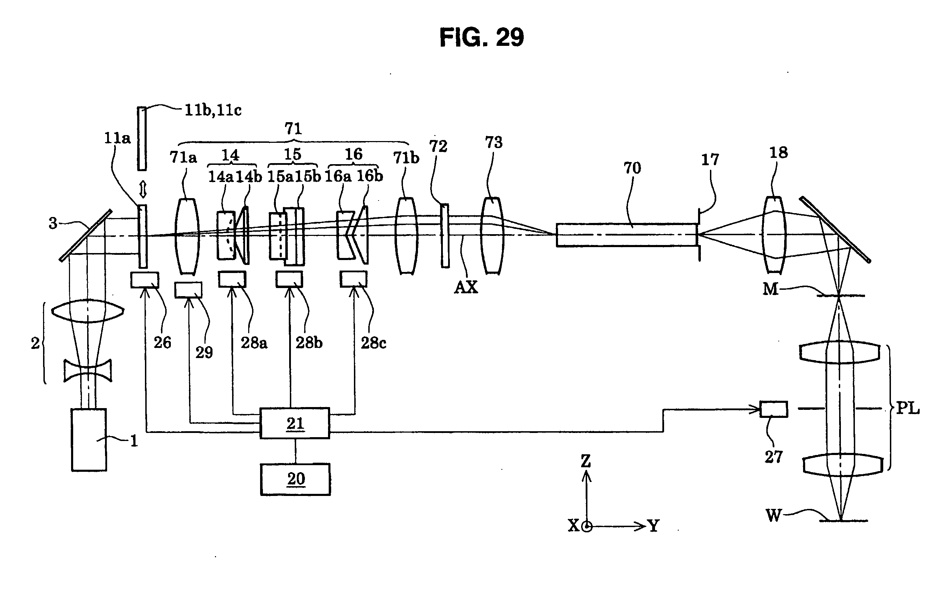

Fig. 29 schematically shows an arrangement of an exposure apparatus provided with an illumination optical apparatus according to a fifth embodiment of the present invention. The fifth embodiment is constructed similarly to the second embodiment. However, the fifth embodiment is basically different from the second embodiment in that an internal reflection type optical integrator (rod type integrator 70) is used in place of the wave front dividing type optical integrator (micro fly's eye 8a). The fifth embodiment will be explained below while paying the attention to the difference from the second embodiment.

In the fifth embodiment, a zoom lens 71, a second diffracting optical element (or a micro fly's eye) 72, and an input lens 73 are arranged in this order from the side of the light source in the optical path between the diffracting optical element 11 and the rod type integrator 70 corresponding to the fact that the rod type integrator 70 is arranged in place of the micro fly's eye 8a. Further, a mask blind 17, which serves as the illumination field stop, is arranged in the vicinity of the light-outgoing plane of the rod type integrator 70.

In this case, the zoom lens 71 is arranged so that the front side focus position is substantially coincident with the position of the diffracting optical element 11, and the rear side focus position is substantially coincident with the position of the second diffracting optical element 72. The focal length of the zoom lens 71 is changed by the aid of a driving system 29 which is operated on the basis of a command from a control system 21. The input lens 73 is arranged so that the front side focus position is substantially coincident with the position of the second diffracting optical element 72, and the rear side focus position is substantially coincident with the position of the light-incoming surface of the rod type integrator 70.

The rod type integrator 70 is a glass rod of the internal reflection type composed of a glass material such as silica glass or fluorite. The rod type integrator 70 forms light source images of a number corresponding to a number of times of internal reflection along the plane which passes through the light-collecting point and which is parallel to the rod light-incoming surface, by utilizing the total reflection at the boundary plane between the inside and the outside, i.e., at the internal surface. In this case, almost all of the formed light source images are virtual images. However, only the light source image at the center (light-collecting point) is a real image. That is, the light beam, which comes into the rod type integrator 70, is divided in the angular direction by means of the internal reflection to form the secondary light source composed of a large number of light source images along the plane which passes through the light-collecting point and which is parallel to the light-incoming surface.

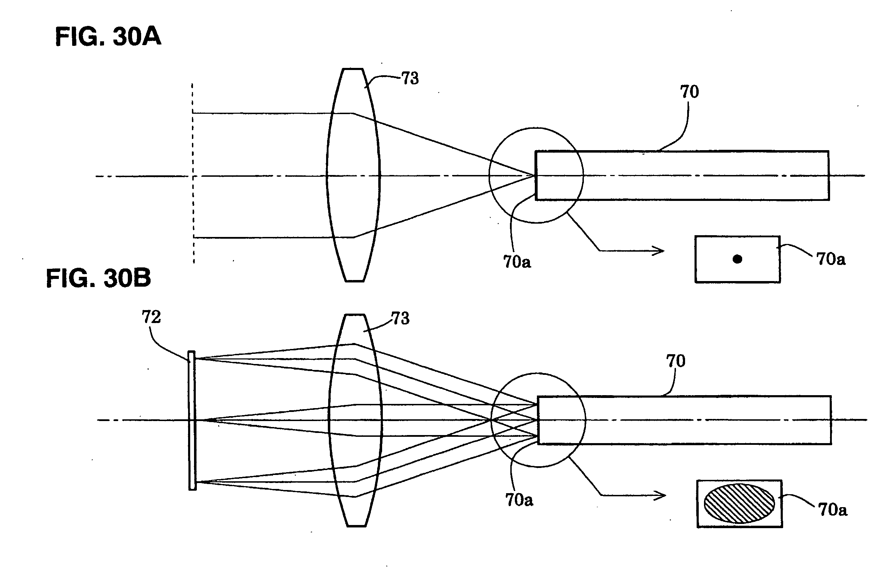

Therefore, in the quadrupole illumination (annular illumination or circular illumination) in the fifth embodiment, the light beam, which has passed through the diffracting optical element 11a (11b or 11c) selectively installed in the illumination optical path, forms the four-spot (annular or circular) illumination field on the second diffracting optical element 72 via the zoom lens 71. The light beam, which has passed through the second diffracting optical element 72, is collected in the vicinity of the light-incoming surface of the rod type integrator 70 via the input lens 73. Fig. 30 illustrates the function of the second diffracting optical element in the fifth embodiment.

As shown in Fig. 30A, if the second diffracting optical element 72 is not arranged, the light beam, which has passed through the zoom lens 71 and the input lens 73, is collected at substantially one point on the light-incoming surface 70a of the rod type integrator 70. As a result, the large number of light sources, which are formed by the rod type integrator 70 on the light-outgoing side, are extremely dissipated (the filling ratio of each light source with respect to the entire secondary light source is small). It is impossible to obtain any substantial surface light source.

Accordingly, in the fifth embodiment, the second diffracting optical element 72, which serves as a light beam-diverging element, is arranged in the vicinity of the front side focus position of the input lens 73. Accordingly, as shown in Fig. 30B, the light beam, which is diverged by the aid of the second diffracting optical element 72, is collected with a predetermined spread on the light-incoming surface 70a of the rod type integrator 70 via the input lens 73. As a result, the large number of light sources, which are formed on the light-incoming side by the rod type integrator 70, are extremely dense and solid (the filling ratio of each light source with respect to the entire secondary light source is large). It is possible to obtain the secondary light source as the substantial surface light source.

The light beams, which come from the four-spot (annular or circular) secondary light sources formed on the light-incoming side by the rod type integrator 70, are superimposed on the light-outgoing plane to subsequently illuminate the mask M formed with a predetermined pattern, via the mask blind 17 and the image-forming optical system 18. In the fifth embodiment, the conical axicon 14, the first V-shaped axicon 15, and the second V-shaped axicon 16 are arranged in this order from the side of the light source in the optical path between the front side lens group 71a and the rear side lens group 71b of the zoom lens 71.

Therefore, also in the quadrupole illumination in the fifth embodiment, the position, the shape, and the size of each of the surface light sources for constructing the annular secondary light source can be appropriately changed in a circular annular area formed about the center of the optical axis AX, by selectively using the plurality of diffracting optical elements 11a for the quadrupole illumination and utilizing the function of the conical axicon 14, the first V-shaped axicon 15, the second V-shaped axicon 16, and the zoom lens 71, in the same manner as in the second embodiment.

Also in the annular illumination in the fifth embodiment, it is possible to appropriately change the entire size and the shape (annular ratio) of the annular secondary light source or the position, the shape, and the size of each of the surface light sources for constructing the two-spot secondary light source or the quadrupole secondary light source derivatively obtained from the annular secondary light source, by selectively using the plurality of diffracting optical elements 11b for the annular illumination and utilizing the function of the conical axicon 14, the first V-shaped axicon 15, the second V-shaped axicon 16, and the zoom lens 7, in the same manner as in the second embodiment.

Also in the circular illumination in the fifth embodiment, it is possible to appropriately change the entire size of the circular secondary light source, or the position, the shape, and the size of each of the surface light sources for constructing the two-spot secondary light source or the quadrupole secondary light source derivatively obtained from the circular secondary light source, by selectively using the plurality of diffracting optical elements 11c for the circular illumination and utilizing the function of the conical axicon 14, the first V-shaped axicon 15, the second V-shaped axicon 16, and the zoom lens 7, in the same manner as in the second embodiment.

As described above, also in the second to fifth embodiments, the entire size and the shape of the secondary light source are changed in the X direction or the Z direction by changing the spacing distance of the V-shaped axicon 15 or 16. As a result, it is possible to realize the mutually different illumination conditions in the orthogonal two directions (X direction and Y direction) on the mask M. Consequently, it is possible to set the optimum illumination condition in the orthogonal two directions on the mask M in which the pattern has orientation.

Among the second to fifth embodiments described above, the third embodiment, which is provided with only the pair of V-shaped axicons 15, 16 as the varying mechanism, is used especially preferably for the lithography step for the memory (for example, DRAM). The fourth embodiment, which is provided with only the conical axicon 14 and one V-shaped axicon (15 or 16) as the varying mechanism, is used especially preferably for the lithography step for the logic device (for example, MPU). The second embodiment and the fifth embodiment, each of which is provided with the conical axicon 14 and the pair of V-shaped axicons 15, 16, are used preferably for the lithography step for the general microdevice including the semiconductor device.

In the fifth embodiment described above (see Fig. 29), the example has been explained, in which the optical integrator arranged on the mask side of the axicon system (14, 15, 16) is the internal reflection type optical integrator (rod type optical integrator) 70. However, it is needless to say that the fly's eye lens 8 or the micro fly's eye 8a as the optical integrator described above can be also replaced with the internal reflection type optical integrator (rod type optical integrator) 70.

In the second embodiment, the third embodiment, and the fifth embodiment described above (see Figs. 10, 25, and 29), the example has been illustrated, in which the direction of the V-groove of the first V-shaped axicon 15 is in the Z direction (0° direction), and the direction of the V-groove of the second V-shaped axicon 16 is the X direction (90° direction). However, the present invention is not limited to this arrangement. For example, the direction of the V-groove of the first V-shaped axicon 15 may be a direction (45° direction) obtained by making clockwise rotation by 45° about the center of the optical axis, and the direction of the V-groove of the second V-shaped axicon 16 may be a direction (135° direction) obtained by making clockwise rotation by 45° about the center of the optical axis. Accordingly, the shadow of the groove incoming into the micro fly's eye 8a is inclined, and it is possible to expect such an effect that the uneven illuminance can be reduced. Further, the angle (angle of intersection), which is formed by the direction of the V-groove of the first V-shaped axicon 15 and the direction of the V-groove of the second V-shaped axicon 16, can be arbitrarily changed depending on a desired illumination condition. In order to change the angle of intersection between the grooves of the two V-shaped axicons as described above, the control system 21 may drive at least one of the driving system 28b and the driving system 28c on the basis of the input information inputted by the aid of the input unit 20 to relatively rotate the first V-shaped axicon 15 and the second V-shaped axicon 16 about the center of the optical axis.

The fourth embodiment (see Fig. 27) described above is illustrative of the case in which the direction of the V-groove of the V-shaped axicon 15 is the Z direction (0° orientation). However, the present invention is not limited to this arrangement. For example, the direction of the V-groove of the V-shaped axicon 15 may be, for example, the direction obtained by making rotation about 45° (45° orientation) about the center of the optical axis, the direction obtained by making rotation about 90° (90° orientation), and the direction obtained by making rotation about 135° (135° orientation). That is, the direction of the V-groove of the V-shaped axicon 15 can be arbitrarily changed depending on a desired illumination condition. As described above, in order to change the direction of the groove of the V-shaped axicon, the control system 21 may drive the driving system 28b on the basis of the input information inputted by the input unit 20 to rotate the V-shaped axicon 15 by a predetermined amount of rotation about the center of the optical axis.

In the respective embodiments described above, it is preferable that the variable range of the σ value is from 0.1 to 0.95 (0.1 ≤ σ ≤ 0.95) by using the diffracting optical element (11a, 11b, 11c) and the zoom lens 7 (magnification-varying optical system) for varying the σ value in combination. However, continuous variation may be made for the range of the σ value of 0.1 to 0.95 required for the apparatus provided that the restriction is abolished, for example, for the number of lenses for constructing the zoom lens 7 (magnification-varying optical system) for varying the σ value and the space therefor.

In the annular illumination in the first to fifth embodiments described above, it is desirable for the annular light beam formed on the pupil of the illumination optical system (pupil of the projection optical system) that the annular ratio is varied within a range of the σ value of 0.4 to 0.95 (0.4 ≤ σ ≤ 0.95). Further, in the multiple-spot illumination represented by the two-spot illumination and the quadrupole illumination in the first to fifth embodiments described above, it is desirable for the multiple-spot light beam formed on the pupil of the illumination optical system (pupil of the projection optical system) that the position and the size are variable within a range of the σ value of 0.4 to 0.95 (0.4 ≤ *σ* ≤ 0.95).

Further, in the first to fifth embodiments described above, in order to measure the aberration which remains in the projection optical system PL or the aberration (for example, the wave front aberration) which is changed in a time-dependent manner, for example, a mask for measuring the aberration (reticle for measuring the aberration), which is disclosed, for example, in United States Patent No. 5,828,455 or United States Patent No. 5,978,085, is placed on an unillustrated mask stage MS for holding the mask (reticle) M, and the mask for measuring the aberration is appropriately illuminated. The content of United States Patent No. 5,828,455 and United States Patent No. 5,978,085 is incorporated herein be reference. Thus, the aberration of the projection optical system PL (for example, the wave front aberration) can be measured highly accurately. As a result of the progressive studies from various viewpoints on the illumination condition under which the aberration of the projection optical system PL (for example, the wave front aberration) can be measured highly accurately, it has been revealed that the σ value of the illumination optical system is preferably set to be any one included in a range of 0.01 ≤ σ ≤ 0.3. In order to measure the aberration of the projection optical system PL (for example, the wave front aberration) further highly accurately, the σ value of the illumination optical system is more preferably set to be any one included in a range of 0.02 ≤ σ ≤ 0.2. In order to set the illumination condition so that the σ value of the illumination optical system is in the range of 0.01 ≤ σ ≤ 0.3 or the range of 0.02 ≤ σ ≤ 0.2, a diffracting optical element for the measurement for setting the locally minimum σ value may be set in place of the diffracting optical element (11a, 11b, 11c) for constructing the part of the illumination condition-setting mechanism (4a, 4b, 5, 7, 10, 11a to 11c, 12, 14 to 16, 71, 71a) in the respective embodiments described above. If any aberration occurs in the projection optical system PL in any one of the first to fifth embodiments described above, the deterioration of the optical characteristic represented by the aberration of the projection optical system PL can be corrected by inputting the measured aberration information into the input unit 20, and allowing the control system 21 to move (move in the optical axis direction of the projection optical system PL, move in the direction perpendicular to the optical axis, incline with respect to the optical axis, and/or rotate about the optical axis) at least one optical element (for example, the lens or the mirror) for constructing the projection optical system PL, for example, by the aid of the unillustrated driving system on the basis of the aberration information inputted by the input unit 20.

When the operator operates the apparatus illustrated in any one of the first to fifth embodiment described above, the operator may change the illumination condition for the illumination optical system depending on a type of mask to be used. For example, the illumination condition may be changed by selecting at least one of the following settings i)-iv):
i) including a step of converting the illumination light beam into one having an annular configuration on the pupil of the illumination optical system, a step of displacing the illumination light beam symmetrically with respect to the optical axis in a first direction which is perpendicular to the optical axis of the illumination optical system, and a step of displacing the illumination light beam symmetrically with respect to the optical axis in a second direction which is perpendicular to the optical axis and which intersects the first direction;
ii) including a step of displacing the illumination light beam symmetrically with respect to the optical axis in the first direction which is perpendicular to the optical axis of the illumination optical system, a step of displacing the illumination light beam symmetrically with respect to the optical axis in the second direction which is perpendicular to the optical axis and which intersects the first direction, and a step of changing a size of the illumination light beam;
iii) including a step of converting the illumination light beam into one having an annular configuration having a desired annular ratio on the pupil of the illumination optical system, and a step of changing a size of the illumination light beam;
iv) including a step of displacing the illumination light beam symmetrically with respect to the optical axis of the illumination optical system in a predetermined direction which is perpendicular to the optical axis, and a step of changing the size of the illumination light beam; and
v) including an annular ratio-varying step of converting the illumination light beam into one having an annular configuration having a desired annular ratio on the pupil of the illumination optical system, a step of displacing the illumination light beam symmetrically with respect to the optical axis of the illumination optical system in the first direction which is perpendicular to the optical axis, and a step of displacing the illumination light beam symmetrically with respect to the optical axis in the second direction which is perpendicular to the optical axis and which intersects the first direction.

For example, the operator may change the illumination condition by selecting at least one setting from one group consisting of the settings i) and ii). The operator may change the illumination condition by selecting at least one setting from another group consisting of the settings iii) and iv). The operator may further change the illumination condition by selecting at least one setting from another group of the settings ii), iii) and v). Needless to say, the order of the steps is not limited to that indicated in the respective settings i)-v), the steps may be performed in any order.

The apparatus illustrated in any one of the first to fifth embodiment described above may be a scanning type exposure apparatus. In this case, the illumination optical system forms a slit-shaped (oblong configuration having a length of the transverse direction and a length of the longitudinal direction) illumination area (illumination area having a length in the scanning direction or the direction of the plane of paper in Figs. 1, 10, 25, 27, and 29) on the mask M. A slit-shaped exposure area is formed on the wafer W. An image of the pattern on the mask M is formed on the wafer W via the projection optical system PL by moving the mask held on an unillustrated mask state MS and the wafer (substrate) held on an unillustrated wafer stage (substrate stage) WS in opposite directions along with the scanning direction (direction of the plane of paper in Figs. 1, 10, 25, 27, and 29). In this case, the unillustrated mask stage MS and the unillustrated wafer stage (substrate stage) WS are controlled by the control system 21 by the aid of the driving apparatus for driving each of the unillustrated stages.

In the apparatus illustrated in each of the embodiments described above, it is preferable that the cross-sectional configuration of each of the large number of optical elements (lens elements) for constructing the micro fly's eye (microarray-shaped optical element) 8a and the fly's eye lens (array-shaped optical element) 8 as the optical integrator is similar to the slit-shaped (oblong configuration having a length of the transverse direction and a length of the longitudinal direction) illumination area formed on the mask M and the slit-shaped (oblong configuration having a length of the transverse direction and a length of the longitudinal direction) exposure area formed on the wafer W.

As illustrated in the respective embodiments described above, in the case of the scanning type exposure apparatus in which the micro fly's eye (microarray-shaped optical element) 8a and/or the fly's eye lens (array-shaped optical element) 8 as the optical integrator is replaced with the internal reflection type optical integrator (rod-type optical integrator), and in the case of the scanning type exposure apparatus in which the optical integrator is the internal reflection type optical integrator (rod-type optical integrator) as in the fifth embodiment, it is preferable that the cross-sectional configuration of the internal reflection type optical integrator (rod-type optical integrator) is similar to the slit-shaped (oblong configuration having a length of the transverse direction and a length of the longitudinal direction) illumination area formed on the mask M and the slit-shaped (oblong configuration having a length of the transverse direction and a length of the longitudinal direction) exposure area formed on the wafer W.

When the apparatus illustrated in each of the embodiments described above is the scanning type exposure apparatus, in order to achieve the scanning exposure at a high throughput while efficiently maintaining the wide field without bring about any large size and any complexity of the projection optical system PL, it is preferable to satisfy a relationship of 0.05 < Ls/L1 < 0.7 provided that Ls represents the length in the transverse direction of the slit-shaped illumination area formed on the mask M (or the slit-shaped exposure area formed on the wafer W), and L1 represents the length in the longitudinal direction of the illumination area. In the scanning type exposure apparatus illustrated in each of the embodiments described above, for example, Ls/L1 =1/3 is given.

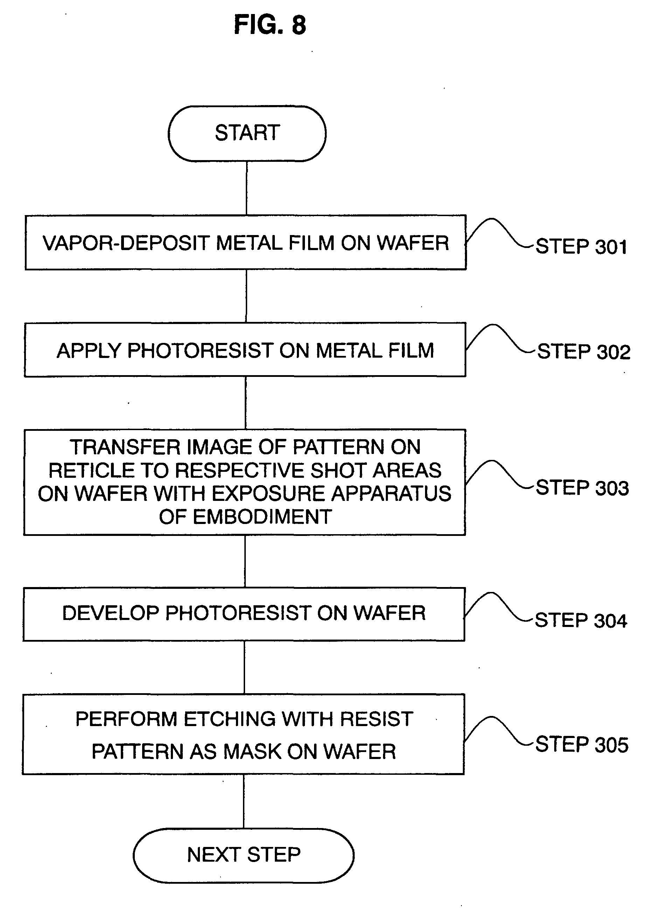

When the exposure apparatus according to each of the embodiments described above is used, it is possible to produce microdevices (for example, semiconductor elements, image pickup elements, liquid crystal display elements, and thin film magnetic heads) by illuminating the mask (reticle) with the illumination optical apparatus (illuminating step), and exposing a photosensitive substrate with a transfer pattern formed on the mask with the projection optical system (exposing step). Explanation will be made below with reference to a flow chart shown in Fig. 8 for an example of the technique adopted when the semiconductor device is obtained as the microdevice by forming a predetermined circuit pattern on the wafer or the like as the photosensitive substrate by using the exposure apparatus illustrated in each of the embodiments described above.

At first, in step 301 in Fig. 8, a metal film is vapor-deposited on one lot of wafers. In the next step 302, a photoresist is applied onto the metal film of one lot of wafers. After that, in step 303, respective shot areas on one lot of wafers are successively subjected to exposure and transfer with an image of a pattern on the mask via the projection optical system by using the exposure apparatus of each of the embodiments described above. After that, in step 304, the photoresist on one lot of wafers is developed, and then etching is performed by using the resist pattern as the mask on one lot of wafers in step 305. Thus, a circuit pattern corresponding to the pattern on the mask is formed on the respective shot areas on the respective wafers. After that, for example, a circuit pattern is formed for further upper layers. Thus, a device such as a semiconductor element is produced. According to the method for producing the semiconductor device described above, the semiconductor device having the extremely fine and minute circuit pattern can be obtained with a good throughput.

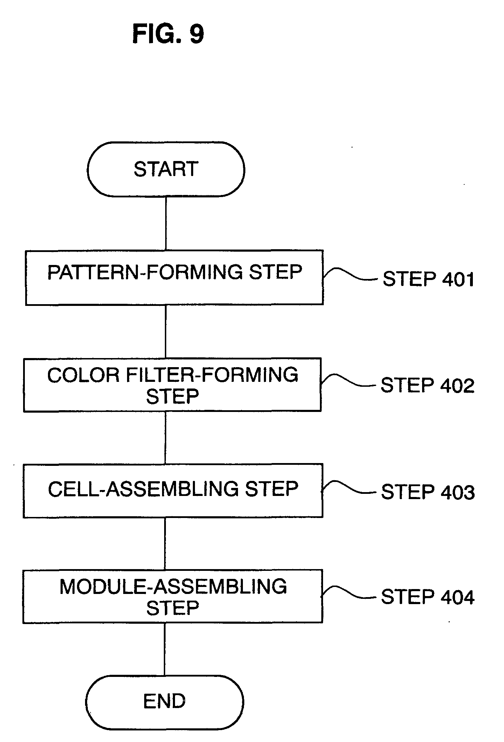

When the exposure apparatus according to each of the embodiments described above is used, a liquid crystal display element as a microdevice can be also obtained by forming a predetermined pattern (for example, a circuit pattern or an electrode pattern) on a plate (glass substrate). An exemplary technique for such a procedure will be explained below with reference to a flow chart shown in Fig. 9. In a pattern-forming step 401 shown in Fig. 9, a so-called lithography step is executed, in which a photosensitive substrate (for example, a glass substrate applied with photoresist) is subjected to transfer and exposure with a pattern on a mask by using the exposure apparatus according to each of the embodiments described above. A predetermined pattern including a large number of electrodes and other components is formed on the photosensitive substrate in accordance with the photolithography step. After that, the exposed substrate is subjected to respective steps including, for example, a development step, an etching step, and reticle-peeling off step. Accordingly, the predetermined pattern is formed on the substrate, and the procedure proceeds to the next color filter-forming step 402.

Subsequently, in the color filter-forming step 402, a color filter is formed, in which a large number of sets of three dots corresponding to R (Red), G (Green), and B (Blue) are arranged in a matrix form, or a plurality of sets of filters of three stripes of R, G, and B are arranged in the horizontal scanning line direction. After the color filter-forming step 402, a cell-assembling step 403 is executed. In the cell-assembling step 403, a liquid crystal panel (liquid crystal cell) is assembled by using, for example, the substrate having the predetermined pattern obtained in the pattern-forming step 401 and the color filter obtained in the color filter-forming step 402. In the cell-assembling step 403, for example, a liquid crystal is injected into the space between the substrate having the predetermined pattern obtained in the pattern-forming step 401 and the color filter obtained in the color filter-forming step 402 to produce a liquid crystal panel (liquid crystal cell).

After that, in a module-assembling step 404, respective parts including, for example, a backlight and an electric circuit for effecting the display action on the assembled liquid crystal panel (liquid crystal cell) are attached to complete the liquid crystal display element. According to the method for producing the liquid crystal display element, it is possible to obtain, with a good throughput, the liquid crystal display element having the extremely fine and minute circuit pattern.

In each of the embodiments described above, the four-spot or annular secondary light source is illustratively formed for the modified illumination. However, it is also possible to form a so-called multi-spot or multiple-spot secondary light source including, for example, a two-spot secondary light source composed of two surface light sources eccentric with respect to the optical axis and an eight-spot secondary light source composed of eight surface light sources eccentric with respect to the optical axis.

In each of the embodiments described above, the present invention has been explained as exemplified by the projection exposure apparatus provided with the illumination optical apparatus. However, it is clear that the present invention is applicable to a general illumination optical apparatus for illuminating an illumination objective plane other than the mask.

As explained above, the illumination optical apparatus according to each embodiment is provided with the aspect ratio-changing element for changing the aspect ratio of the incoming light beam in order to change the angle of incidence of the incoming light beam in the predetermined direction into the optical integrator. Therefore, the entire size of the secondary light source can be changed in the predetermined direction owing to the function of the aspect ratio-changing element. Consequently, it is possible to realize the mutually different illumination conditions in the orthogonal two directions on the illumination objective plane.

Therefore, the exposure apparatus, which is incorporated with the illumination optical apparatus according to each embodiment, is capable of setting the optimum illumination conditions in the orthogonal two directions on the mask in which the pattern has orientation. It is possible to produce the good microdevice under the satisfactory illumination condition. Further, according to the present invention, the pattern on the mask can be correctly transferred under the suitable illumination condition. Simultaneously, for example, it is possible to realize the exposure method and the exposure apparatus which make it possible to highly accurately confirm the optical performance of the projection optical system when the pattern on the mask is correctly transferred. Further, it is possible to produce the good microdevice.

## Claims

1. An illumination optical apparatus for illuminating an illumination objective plane with a light beam from a light source, comprising:
an optical integrator (6, 8, 8a) which is arranged in an optical path between the light source (1) and the illumination objective plane and forms a multiple light source on the basis of the light beam from the light source; and
an aspect ratio-changing element (10, 15, 16) which is arranged in an optical path between the light source and the optical integrator and changes an aspect ratio of an incoming light beam in order to change an angle of incidence of the incoming light beam in a predetermined direction into the optical integrator.

2. The illumination optical apparatus according to claim 1, wherein:
the optical integrator includes a first optical integrator (6) which is arranged in an optical path between the light source and the illumination objective plane and forms a first multiple light source on the basis of the light beam from the light source, and a second optical integrator (8) which is arranged in an optical path between the first optical integrator and the illumination objective plane and forms a second multiple light source having light sources of a number larger than that of the first multiple light source on the basis of a light beam from the first multiple light source; and
the illumination optical apparatus further comprises a magnification-varying optical system (7) which is arranged in an optical path between the first optical integrator (6) and the second optical integrator (8) and which similarly changes an entire size of the second multiple light source.

3. The illumination optical apparatus according to claim 2, wherein the aspect ratio-changing element is constructed to be rotatable about a center of an optical axis of the aspect ratio-changing element.

4. The illumination optical apparatus according to claim 2, wherein the aspect ratio-changing element includes a first aspect ratio-changing element (10, 16) which is arranged in the optical path between the light source and the first optical integrator and changes an angle of incidence of the incoming light beam into the first optical integrator in a first direction, and a second aspect ratio-changing element (15) which is arranged in the optical path between the light source and the first optical integrator and changes an angle of incidence of the incoming light beam into the first optical integrator in a second direction perpendicular to the first direction.

5. The illumination optical apparatus according to claim 2, wherein the aspect ratio-changing element includes a first prism (10a, 15a, 16a) which has a refractive surface having a concave cross section in the predetermined direction, a second prism (10b, 15b, 16b) which has a refractive surface having a convex cross section formed complementarily with the refractive surface having the concave cross section of the first prism, and a driving unit (25, 28c) which is connected to at least one of the first prism and the second prism and moves at least one of the first prism and the second prism along an optical axis.

6. The illumination optical apparatus according to claim 5, wherein the concave cross section of the first prism has a V-shaped configuration.

7. An exposure apparatus for transforming a pattern on a mask onto a workpiece comprising:
the illumination optical apparatus according to claim 1, which illuminates the mask (M) arranged at the illumination objective plane; and
a projection optical system (PL) which is arranged in an optical path between the mask and the workpiece and projects an image of the pattern onto the workpiece.

8. A method for producing a microdevice, comprising an exposing step of exposing the workpiece with the pattern on the mask with the exposure apparatus as defined in claim 7, and a developing step of developing the workpiece (W) exposed in the exposing step.

9. The illumination optical apparatus according to claim 1, further comprising a guiding optical system (9, 17, 18) which is arranged in an optical path between the optical integrator and the illumination objective plane and guides the light beam from the optical integrator to the illumination objective plane, and a light beam-converting element (4, 4a, 11a, 11b, 11c) which is arranged in the optical path between the light source and the optical integrator and converts the light beam from the light source into a light beam having a predetermined cross-sectional configuration or a light beam having a predetermined light intensity distribution.

10. The illumination optical apparatus according to claim 9, wherein the aspect ratio-changing element (10, 15, 16) is constructed to be rotatable about a center of an optical axis of the aspect ratio-changing element.

11. The illumination optical apparatus according to claim 9, wherein the aspect ratio-changing element includes a first aspect ratio-changing element (10, 16) which is arranged in the optical path between the light source and the optical integrator and changes an angle of incidence of the incoming light beam into the optical integrator in a first direction, and a second aspect ratio-changing element (16) which is arranged in the optical path between the light source and the optical integrator and changes an angle of incidence of the incoming light beam into the optical integrator in a second direction traverse to the first direction.

12. The illumination optical apparatus according to claim 9, wherein the aspect ratio-changing element includes a first prism (10a, 15a, 16a) which has a refractive surface having a concave cross section in the predetermined direction, a second prism (10b, 15b, 16b) which has a refractive surface having a convex cross section formed complementarily with the refractive surface having the concave cross section of the first prism, and a driving unit (25, 28c) which is connected to at least one of the first prism and the second prism and moves at least one of the first prism and the second prism along an optical axis.

13. The illumination optical apparatus according to claim 12, wherein the concave cross section of the first prism has a V-shaped configuration.

14. An illumination optical apparatus comprising:
an illumination optical system which illuminates an illumination objective; and
a varying mechanism (7, 14, 15, 16) which is attached to the illumination optical system and varies at least one of a size and a shape of an illumination light beam on a pupil of the illumination optical system, wherein:
the varying mechanism includes a first displacement unit (15) which is arranged in an illumination optical path and displaces the illumination light beam symmetrically with respect to an optical axis of the illumination optical system in a first direction perpendicular to the optical axis.

15. The illumination optical apparatus according to claim 14, wherein the varying mechanism further includes a second displacement unit (16) which is arranged in the illumination optical path and displaces the illumination light beam symmetrically with respect to the optical axis in a second direction which is perpendicular to the optical axis and which intersects the first direction, and a magnification-varying optical system (7) which is arranged in the illumination optical path and varies the size of the illumination light beam.

16. The illumination optical apparatus according to claim 15, wherein the illumination optical system includes a light shape converter (4, 4a, 11a, 11b, 11c) which is arranged in the illumination optical path and converts the shape of the illumination light beam into a desired light beam shape and which guides the illumination light beam converted to have the desired light beam shape to the varying mechanism.

17. The illumination optical apparatus according to claim 16, wherein the light shape converter includes a first diffractive optical member (4, 11a) which is capable of inserting the illumination optical path and converts the shape of the illumination light beam into a first light beam shape, and a second diffractive optical member (4a, 11b, 11c) which is provided exchangeably with the first diffractive optical member and which converts the shape of the illumination light beam into a second light beam shape.

18. The illumination optical apparatus according to claim 15, wherein the illumination optical system includes an optical integrator (8a) which is arranged in an optical path between the varying mechanism and the illumination objective and which uniformly illuminates the illumination objective.

19. The illumination optical apparatus according to claim 18, wherein the optical integrator is a micro fly's eye or a rod type integrator (70).

20. An exposure apparatus for transforming a pattern on a mask onto a workpiece comprising:
the illumination optical apparatus according to claim 14, which illuminates the mask arranged at the illumination objective plane; and
a projection optical system (PL) which is arranged in an optical path between the mask (M) and the workpiece (W) and projects an image of the pattern onto the workpiece.

21. A method for producing a microdevice, comprising an exposing step of exposing the workpiece (W) with the pattern on the mask (M) with the exposure apparatus as defined in claim 20, and a developing step of developing the workpiece (W) exposed in the exposing step.

22. The illumination optical apparatus according to claim 14, wherein the varying mechanism further includes an annular ratio-varying unit (14) which is arranged in the illumination optical path and converts the illumination light beam into one having an annular configuration with a desired annular ratio.

23. The illumination optical apparatus according to claim 22, wherein the varying mechanism (7, 14, 15, 16) includes a magnification-varying optical system (7) which is arranged in the illumination optical path and varies the size of the illumination light beam.

24. The illumination optical apparatus according to claim 22, wherein the varying mechanism (7, 14, 15,16) further includes a second displacement unit (16) which is arranged in the illumination optical path and displaces the illumination light beam symmetrically with respect to the optical axis in a second direction which is perpendicular to the optical axis and which intersects the first direction.

25. The illumination optical apparatus according to claim 22, wherein the illumination optical system includes a light shape converter (4, 4a, 11a, 11b, 11c) which is arranged in the illumination optical path and converts the shape of the illumination light beam into a desired light beam shape and which guides the illumination light beam converted to have the desired light beam shape to the varying mechanism.

26. The illumination optical apparatus according to claim 25, wherein the light shape converter (4, 4a, 11a, 11b, 11c) includes a first diffractive optical member (4, 11a) which is capable of inserting the illumination optical path and converts the shape of the illumination light beam into a first light beam shape, and a second diffractive optical member (4, 11b, 11c) which is provided exchangeably with the first diffractive optical element and which converts the shape of the illumination light beam into a second light beam shape.

27. The illumination optical apparatus according to claim 22, wherein the illumination optical system includes an optical integrator (8a) which is arranged in an optical path between the varying mechanism and the illumination objective and which uniformly illuminates the illumination objective.

28. The illumination optical apparatus according to claim 22, wherein the annular ratio-varying unit is a conical axicon (14).

29. An exposure method for exposing a workpiece (W) with a pattern on a mask (M), comprising:
an illuminating step of illuminating the mask via an illumination optical system with an optical axis; and
a projecting step of projecting an image of the pattern on the mask (M) onto the workpiece (W), wherein:
the illuminating step comprises displacing an illumination light beam symmetrically with respect to an optical axis of the illumination optical system in a first direction perpendicular to the optical axis on a pupil of the illumination optical system.

30. The exposure method according to claim 29, wherein the illuminating step further comprises converting the illumination light beam into one having an annular configuration on the pupil of the illumination optical system (PL), and displacing the illumination light beam symmetrically with respect to the optical axis in a second direction which is perpendicular to the optical axis and which intersects the first direction.

31. The exposure method according to claim 30, wherein the illuminating step further comprises changing a size of the illumination light beam.

32. The exposure method according to claim 30, wherein the illuminating step further comprises converting a shape of the illumination light beam into a desired light beam shape before converting the illumination light beam into one having the annular configuration.

33. The exposure method according to claim 29, wherein the illuminating step further comprises displacing the illumination light beam symmetrically with respect to the optical axis in a second direction which is perpendicular to the optical axis and which intersects the first direction, and changing a size of the illumination light beam.

34. The exposure method according to claim 33, wherein the illuminating step further comprises converting a shape of the illumination light beam into a desired light beam shape before displacing the illumination light beam.

35. The exposure method according to claim 29, wherein the illuminating step further comprises converting the illumination light beam into one having an annular configuration on the pupil of the illumination optical system, and converting an annular ratio of the converted annular illumination into a desired annular ratio.

36. The exposure method according to claim 35, wherein the illumination step further comprises changing a size of the illumination light beam.

37. The exposure method according to claim 35, wherein the illuminating step further comprises a second displacing step of displacing the illumination light beam symmetrically with respect to the optical axis in a second direction which is perpendicular to the optical axis and which intersects the first direction.

38. The exposure method according to claim 35, wherein the illuminating step further comprises converting a shape of the illumination light beam into a desired light beam shape before converting the illumination light beam into one having the annular configuration.

39. The exposure method according to claim 38, wherein the light shape-converting step includes converting the shape of the illumination light beam into a first light beam shape by using a first diffractive optical member (4, 11a), and converting the shape of the illumination light beam into a second light beam shape by using a second diffractive optical member (4a, 11b, 11c) which is provided exchangeably with the first diffractive optical member.

40. The exposure method according to claim 35, wherein the illuminating step comprises uniformly illuminating the illumination objective by using an optical integrator(8a).

41. The exposure method according to claim 29, wherein:
the illuminating step further comprises a changing step of changing an illumination condition for the mask;
the changing step comprises a selecting step of selecting at least one of a first setting step of setting a first illumination condition for the illumination optical system, and a second setting step of setting a second illumination condition for the illumination optical system;
the first setting step comprises a step of converting the illumination light beam into one having an annular configuration on the pupil of the illumination optical system, a step of displacing the illumination light beam symmetrically with respect to the optical axis in the first direction which is perpendicular to the optical axis of the illumination optical system, and a step of displacing the illumination light beam symmetrically with respect to the optical axis in a second direction which is perpendicular to the optical axis and which intersects the first direction; and
the second setting step comprises a step of displacing the illumination light beam symmetrically with respect to the optical axis in the first direction which is perpendicular to the optical axis of the illumination optical system, a step of displacing the illumination light beam symmetrically with respect to the optical axis in the second direction which is perpendicular to the optical axis and which intersects the first direction, and a step of changing a size of the illumination light beam.

42. The exposure method according to claim 29, wherein:
the illuminating step further comprises a changing step of changing an illumination condition for the mask;
the changing step comprises a selecting step of selecting at least one of a first setting step of setting a first illumination condition for the illumination optical system, and a second setting step of setting a second illumination condition for the illumination optical system;
the first setting step comprises a step of converting the illumination light beam into one having an annular configuration having a desired annular ratio on the pupil of the illumination optical system, and a step of changing a size of the illumination light beam; and
the second setting step comprises a step of displacing the illumination light beam symmetrically with respect to the optical axis of the illumination optical system in a predetermined direction which is perpendicular to the optical axis, and a step of changing the size of the illumination light beam.

43. The exposure method according to claim 29, wherein:
the illuminating step further comprises a changing step of changing an illumination condition for the mask;
the changing step comprises a selecting step of selecting at least one of a first setting step of setting a first illumination condition for the illumination optical system, a second setting step of setting a second illumination condition for the illumination optical system, and a third setting step of setting a third illumination condition for the illumination optical system;
the first setting step comprises an annular ratio-varying step of converting the illumination light beam into one having an annular configuration having a desired annular ratio on the pupil of the illumination optical system, a step of displacing the illumination light beam symmetrically with respect to the optical axis of the illumination optical system in the first direction which is perpendicular to the optical axis, and a step of displacing the illumination light beam symmetrically with respect to the optical axis in a second direction which is perpendicular to the optical axis and which intersects the first direction;
the second setting step comprises a step of converting the illumination light beam into one having an annular configuration having a desired annular ratio, and a step of changing a size of the illumination light beam; and
the third setting step comprises a step of displacing the illumination light beam symmetrically with respect to the optical axis of the illumination optical system in the first direction which is perpendicular to the optical axis, a step of displacing the illumination light beam symmetrically with respect to the optical axis in the second direction which is perpendicular to the optical axis and which intersects the first direction, and a step of changing the size of the illumination light beam.

44. An exposure method for exposing a workpiece (W) with a pattern on a mask (M) comprising:
an illuminating step of illuminating the mask via an illumination optical system;
a projecting step of projecting an image of the pattern on the mask onto the workpiece by using a projection optical system (PL); and
a measuring step of measuring an optical characteristic of the projection optical system, wherein the illuminating step comprises:
an exposure condition-setting step of setting a σ value as an illumination condition to be within a range of 0.4 ≤ σ ≤ 0.95 when the projecting step is executed; and
a measuring condition-setting step of setting the σ value as the illumination condition to be within a range of 0.01 ≤ σ ≤ 0.3 when the measuring step is executed.

45. The exposure method according to claim 44, further comprising:
a scanning step of moving the mask and the workpiece in a scanning direction when the projecting step is executed, wherein:
the illuminating step comprises a step of forming a rectangular illumination area having a length Ls of a longitudinal direction and a length L1 of a transverse direction on the mask; and
a relationship of 0.05 < Ls/L1 < 0.7 is satisfied.

46. An exposure apparatus for exposing a workpiece (W) with a pattern on a mask (M), comprising:
an illumination optical system which is arranged in an optical path upstream of the mask and illuminates the mask; and
a projection optical system (PL) which is arranged in an optical path between the mask and workpiece and projects an image of the pattern on the mask onto the workpiece, wherein:
the illumination optical system includes an illumination condition-setting mechanism (4a, 4b, 5, 7, 10, 11a-11c, 12, 14-16, 71, 71a) which is attached to the illumination optical system and sets a σ value as an illumination condition to be within a range of 0.4 ≤ σ ≤ 0.95 when the workpiece is exposed with the pattern on the mask and which sets the σ value as the illumination condition to be within a range of 0.01 ≤ σ ≤ 0.3 when an optical characteristic of the projection optical system is measured.

47. The exposure apparatus according to claim 46, further comprising a scanning unit which moves the mask and the workpiece in a scanning direction when the workpiece is exposed with the pattern on the mask, wherein:
a relationship of 0.05 < Ls/L1 < 0.7 is satisfied provided that Ls represents a length in a transverse direction of an illumination area formed on the mask by the illumination optical system, and L1 represents a length in a longitudinal direction of the illumination area formed on the mask by the illumination optical system.
